(19) Europäisches Patentamt / European Patent Office / Office européen des brevets

(11) **EP 2 412 782 B1**

(12) **EUROPEAN PATENT SPECIFICATION**

(45) Date of publication and mention of the grant of the patent:
**11.03.2015 Bulletin 2015/11**

(21) Application number: **10756253.0**

(22) Date of filing: **26.03.2010**

(51) Int Cl.:
*C09K 11/64* (2006.01)        *C09K 11/08* (2006.01)
*H01J 29/20* (2006.01)        *H01J 31/15* (2006.01)
*H01L 33/32* (2010.01)

(86) International application number:
**PCT/JP2010/055465**

(87) International publication number:
**WO 2010/110457 (30.09.2010 Gazette 2010/39)**

(54) **PHOSPHOR, METHOD FOR PRODUCING SAME, LIGHT-EMITTING DEVICE, AND IMAGE DISPLAY APPARATUS**

Leuchtstoff, VERFAHREN ZUR HERSTELLUNG DES LEUCHTSTOFFS, LICHTEMITTIERENDES BAUELEMENT UND BILDANZEIGEVORRICHTUNG

LUMINOPHORE, SON PROCÉDÉ DE PRODUCTION, DISPOSITIF ÉLECTROLUMINESCENT, ET APPAREIL POUR L'AFFICHAGE D'IMAGES

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **26.03.2009 JP 2009076761**
**26.06.2009 JP 2009151934**

(43) Date of publication of application:
**01.02.2012 Bulletin 2012/05**

(73) Proprietor: **National Institute for Materials Science Tsukuba-shi, Ibaraki 305-0047 (JP)**

(72) Inventor: **HIROSAKI, Naoto Tsukuba-shi Ibaraki 305-0047 (JP)**

(74) Representative: **Von Kreisler Selting Werner - Partnerschaft von Patentanwälten und Rechtsanwälten mbB Deichmannhaus am Dom Bahnhofsvorplatz 1 50667 Köln (DE)**

(56) References cited:
**WO-A1-2006/118321        JP-A- 2006 307 182**
**JP-A- 2007 231 245        JP-A- 2009 108 223**
**JP-A- 2009 167 328        JP-B2- 3 837 588**

• **Y. Q. LI ET AL: "Yellow-Orange-Emitting CaAlSiN 3 :Ce 3+ Phosphor: Structure, Photoluminescence, and Application in White LEDs", CHEMISTRY OF MATERIALS, vol. 20, no. 21, 20 October 2008 (2008-10-20), pages 6704-6714, XP55036814, ISSN: 0897-4756, DOI: 10.1021/cm801669x**
• **R-J XIE ET AL: "White light-emitting diodes (LEDs) using (oxy)nitride phosphors; White LEDs using (oxy)nitride phosphors", JOURNAL OF PHYSICS D. APPLIED PHYSICS, IOP PUBLISHING, BRISTOL, GB, vol. 41, no. 14, 21 July 2008 (2008-07-21) , page 144013, XP020133503, ISSN: 0022-3727**
• **CAO G Z ET AL: "alpha.'-Sialon ceramics: a review", CHEMISTRY OF MATERIALS, AMERICAN CHEMICAL SOCIETY, WASHINGTON, US, vol. 3, no. 2, 1 March 1991 (1991-03-01), pages 242-252, XP002590722, ISSN: 0897-4756, DOI: 10.1021/CM00014A009**
• **K. UHEDA ET AL: "Host lattice materials in the system Ca 3 N 2 -AlN-Si 3 N 4 for white light emitting diode", PHYSICA STATUS SOLIDI (A), vol. 203, no. 11, 1 September 2006 (2006-09-01), pages 2712-2717, XP55008880, ISSN: 1862-6300, DOI: 10.1002/pssa.200669576**

- XIE RONG-JUN ET AL: "Highly efficient white-light-emitting diodes fabricated with short-wavelength yellow oxynitride phosphors", APPLIED PHYSICS LETTERS, AIP, AMERICAN INSTITUTE OF PHYSICS, MELVILLE, NY, US, vol. 88, no. 10, 6 March 2006 (2006-03-06) , pages 101104-1-101104-5, XP012080442, ISSN: 0003-6951, DOI: 10.1063/1.2182067
- R.-J. XIE ET AL: "Strong Green Emission from [alpha]-SiAION Activated by Divalent Ytterbium under Blue Light Irradiation", THE JOURNAL OF PHYSICAL CHEMISTRY B, vol. 109, no. 19, 23 April 2005 (2005-04-23), pages 9490-9494, XP55038986, ISSN: 1520-6106, DOI: 10.1021/jp050580s
- Y. Q. LI ET AL.: 'Yellow-Orange-Emitting CaAlSiN3:Ce 3+ Phosphor: Structure, Photoluminescence, and Application in White LEDs' CHEM. MATER. vol. 20, 12 October 2008, pages 6704 - 6714, XP055036814

**Description**

Field Of The Invention

The present invention relates to a phosphor comprising a $CaAlSiN_3$ group crystal as a host crystal and a manufacturing method and an application of the same.

Background Art

A phosphor which emits green light, yellow light, orange light, red light or the like is utilized in a fluorescent display tube (VFD), a field emission display (EFD), a plasma display panel (PDP), a cathode-ray tube (CRT), a white color emission diode (LED), and so on. In any of these applications, it is necessary to provide the phosphor with energy to excite the phosphor in order to make the phosphor emit the fluorescence and the phosphor is excited by an excitation source with high energy such as a vacuum ultraviolet ray, an ultraviolet ray, an electron beam, blue light, or the like so as to emit a visible light ray.

A phosphor having nitride as a host crystal is used for these applications (for example, refer to patent reference 1). The patent reference 1 reports a phosphor comprising a $CaAlSiN_3$ crystal or a crystal having the same type of crystal structure as that of the $CaAlSiN_3$ crystal, into which an optically activating element such as rare earth element is incorporated in a solid solution state. A phosphor comprising the $CaAlSiN_3$ crystal to which Eu is added becomes a red phosphor and it is effective in improving color rendering properties of the white color LED to utilize such red phosphor. A phosphor to which Ce was added as an optically activating element was reported to be an orange phosphor.

As a similar phosphor, $Ca_{1-2x}Ce_xLi_xAlSiN_3$ (x=0.01) and $Ca_{1-x}Ce_xAlSiN_{3-2x/3}O_{3x/2}$ (x=0.01) as a yellow phosphor comprising a $CaAlSiN_3$ group crystal including Li or oxygen, to which Ce was added, were reported (for example, refer to non-patent reference 1).

Luminescent properties of (oxy)nitride phosphors in the system of M-Si-Al-O-N (M=Li, Ca or Sr), and optical properties of white LEDs using a GaN-based blue LED and (oxy)nitride phosphors was reported in non-patent reference 2. The phosphors showed high conversion efficiency of blue light, suitable emission colors and small thermal quenching. It was indicated that (oxy)nitride phosphorus demonstrated their superior suitability to use as down-conversion luminescent materials in white LEDS.

The state of the art of $\alpha$-Sialon ceramics including phase equilibria, formation, sintering, and properties are described in non-patent reference 3. Use of Li in CaSiAlON:Ce phosphors is also described therein.

It was reported that a red phosphor of $CaAlSiN_3$:Eu to be effectively excited by blue-GaN and near UV-GaInN LED chips was synthesized at 1600 °C for 2 hours and subsequently at 1800 °C for 2 hours under nitrogen pressure of 1 MPa in non-patent reference 4.

It was also reported that a greenish yellow Li-$\alpha$-SiAlON:Eu$^{2+}$ phosphor was used to create daylight when coupled to an InGaN blue LED chip (460 nm) and that the Li-$\alpha$-SiAlON:Eu$^{2+}$ phosphor emitted at shorter wavelengths of 573-577 nm under the 460 nm excitation (see non-patent reference 5).

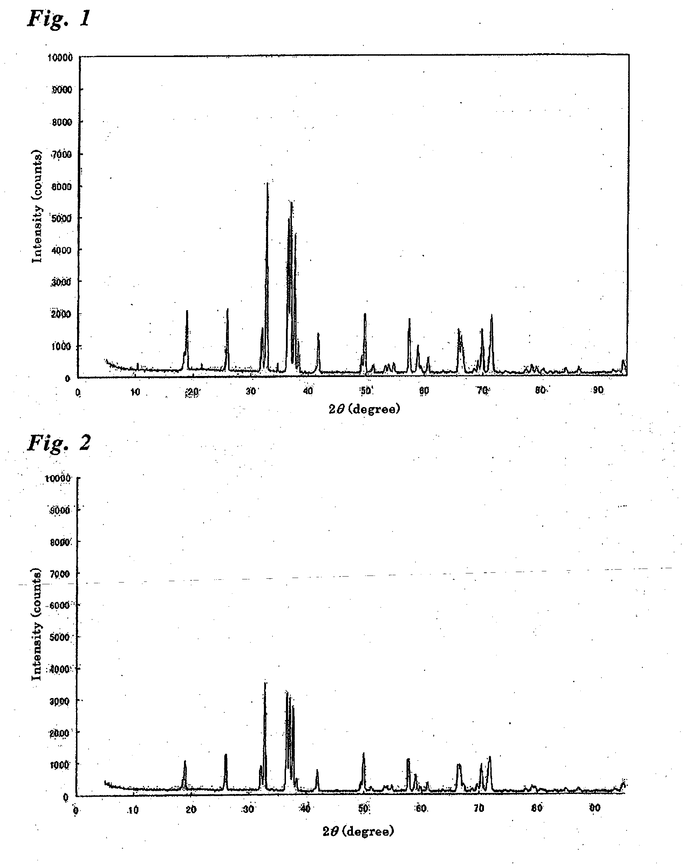

A similar phosphor CaSiAlON:Yb was also reported such that UV-visible diffuse reflectance spectra of Ca-$\alpha$-SiAlON samples doped with varying ytterbium concentration were shown (see Figure 1 of non-patent reference 6).

A phosphor comprising the $CaAlSiN_3$ group crystal to which Eu or Ce was added was also reported (for example, refer to patent reference 2). According to the patent reference 2, a phosphor having a composition of $0.82(Ce_yCa_{1-y}AlSiN_3) \cdot 0.18(Si_2N_2O)$ or $0.61(Ce_y(Ca,Sr)_{1-y}AlSiN_3) \cdot 0.39(LiSi_2N_3)$ was synthesized. However, it is believed that none of the phosphors have had sufficient emission efficiency. In such $CaAlSiN_3$ group crystal, a phosphor exhibiting a bright emission of sufficiently-high intensity has been in demand.

Prior Art References

Patent Reference

[Patent reference 1] Japanese patent No. 3837588.
[Patent reference 2] Japanese Patent Application Publication No. 2007-231245

Nonpatent Reference

[Nonpatent Reference 1] Y.Q.Li et al., "Yellow-Orange-Emitting CaAlSiN3:Ce3+ Phosphor: Structure, Photoluminescence, and Application in White LEDs", Chem. Mater., 20, 6704-6714 (2008)

[Nonpatent Reference 2] R-J Xie et al., "White light-emitting diodes (LEDs) using (oxy)nitride phosphors, Journal of Physics D. Applied Physics, IOP Publishing, Bristol, GB, vol. 41, 21 July 2008 (2008-07-21), page 144013.

[Nonpatent Reference 3] Cao G Z et al., "α-Sialon ceramics: a review", Chemistry of Materials, American Chemical Society, Washington US, vol. 3, no. 2, 1 March 1991 (1991-03-01), pages 242-252.

[Nonpatent Reference 4] K. Uheda et al., "Host lattice materials in the system Ca3N2-AlN-Si3N4 for white light emitting diode", Physica Status Solidi (A), vol. 203, no. 11, 1 September 2006 (2006-09-01), pages 2712-2717.

[Nonpatent Reference 5] Xie Rong-Jun et al., "Highly efficient white-light-emitting diodes fabricated with short-wavelength yellow oxynitride phosphors", Applied Physics Letters, AIP, American Institute of Physics, Melville, NY, US, vol. 88, no. 10, 6 March 2006 (2006-03-06), pages 101104-101104.

[Nonpatent Reference 6] R-J Xie et al., "Strong Green Emission from α-SiAlON Activated by Divalent Ytterbium under Blue Light Irradiation", The Journal of Physical Chemistry B, vol. 109, no. 19, 23 April 2005 (2005-04-23), pages 9490-9494.

Summary Of The Invention

Problem To Be Solved By The Invention

An object of the present ivnetion is to provide a phosphor exhibiting a bright emission of sufficiently-high intensity which comprises the $CaAlSiN_3$ group crystal as a host crystal, to provide a manufacturing method and an application of the aforementioned phosphor, and more specifically to provide a phosphor emitting yellow, orange, or red fluorescence by controlling a composition thereof and a manufacturing method and an application of such phosphor.

Means to Solve The Problem

The present inventor has been investigating a phosphor activated with Ce to become a luminescence center, which comprises the $CaAlSiN_3$ group crystal as the host crystal. And it was found that a phosphor capable of exhibiting a bright emission of higher intensity by being constituted of certain elements could be obtained. That is, the present inventor successfully provided a phosphor comprising a $CaAlSiN_3$ crystal or a crystal having the same crystal structure as the $CaAlSiN_3$ crystal as the host crystal wherein the phosphor comprises at least Li, Ca, Si, Al, O (oxygen), N (nitrogen), and Ce elements, wherein an atomic fraction of a of Ce and an atomic fraction of b of Li satisfy: $b \geq 1.2 \times a$.

Effect Of The Invention

A phosphor of the present invention comprises at least Li, Ca, Si, Al, O(oxygen), N (nitrogen), and Ce elements and exhibits high emission efficiency and high emission brightness as Ce is incorporated into the $CaAlSiN_3$ crystal or a crystal having the same crystal structure as the $CaAlSiN_3$ crystal (hereinafter, collectively being referred to as $CaAlSiN_3$ group crystal) as a host crystal of the phosphor. Further, a phosphor having a specific composition in which an amount of Li and an amount of Ce are controlled is excellent in particular as a yellow, orange, or red phosphor since the phosphor exhibits an emission spectrum having a peak in a wavelength ranage of at least 560 nm and not exceeding 620 nm. Further, a useful phosphor to be utilized in a VFD, an FED, a PDP, a CRT, a white color LED, and so on is provided wherein the brightness of the phosphor does not deteriorate in particular even if it is exposed to the excitation source since the phosphor is chemically stable.

Brief Description Of The Drawings

Fig. 1 is a diagram showing an X-ray diffraction pattern of a phosphor of Example 2.
Fig. 2 is a diagram showing an X-ray diffraction pattern of a phosphor of Example 29.
Fig. 3 is a diagram showing excitation and emission spectra of a phosphor of Example 2.
Fig. 4 is a diagram showing excitation and emission spectra of a phosphor of Example 11.
Fig. 5 is a diagram showing excitation and emission spectra of a phosphor of Example 17.
Fig. 6 is a diagram showing excitation and emission spectra of a phosphor of Example 29.
Fig. 7 is a diagram showing a relationship between emission wavelength and atomic fraction a of Ce.
Fig. 8 is a diagram showing a relationship between emission intensity and atomic fraction b of Li.
Fig. 9 is a diagram showing a relationship between emission intensity and atomic fraction g of O.

Fig. 10 is a schematic view of an emission device (a bullet-type of white color light-emitting diode lamp).
Fig. 11 is a schematic view of an emission device (a substrate-mounted chip type of white emitting diode lamp).
Fig. 12 is a schematic view of an image display device (a plasma display panel).
Fig. 13 is a schematic view of an image display device (a field emission display panel).

Embodiment For Carrying Out The Invention

As described in detail in the following, the phosphor comprising as a host the $CaAlSiN_3$ crystal and a crystal having the same structure, in which Ca or N of the $CaAlSiN_3$ crystal is replaced with another element, has been closely investigated and it was found that a phosphor comprising a crystal of a certain composition, into which Li and oxygen were incorporated in a solid solution state, as the host crystal ($CaAlSiN_3$ group crystal to be described later), the crystal being activated with Ce, exhibited a highly-intense emission. It was also found that it was possible to control an emission wavelength of a phosphor to have a peak in a wavelength range of at least 560 nm and not exceeding 620 nm, i.e., in the wavelength range of yellow, orange, and red colors by controlling the composition of the phosphor. Hereafter, the present invention is described in detail.

The phosphor of the present invention comprises at least Li, Ca, Si, Al, O (oxygen), N (nitrogen), and Ce elements; and, as the host crystal, the $CaAlSiN_3$ crystal or a crystal having the same crystal structure as the $CaAlSiN_3$ crystal. The crystal having the same crystal structure as the $CaAlSiN_3$ crystal is, for example, a $LiSi_2N_3$ crystal, a $Si_2N_2O$ crystal, $SrAlSiN_3$, $NaSi_2N_3$, and a solid solution crystal thereof. In the present specification, these host crystals are referred to as a $CaAlSiN_3$ group crystal. The phosphor of the present invention may include Sr and/or a metal element other than Ce, Li, Ca (and Sr), Si and Al as necessary. Alternatively, it may essentially consist of Li, Ca, Sr, Si, Al, O (oxygen), N (nitrogen), and Ce elements.

An atomic fraction a of Ce in the phosphor of the present invention satisfies:

$$0.0005 \leq a \leq 0.02 \ .$$

Here, in the present specification, the atomic fractions are defined as proportions of numbers of atoms included in a unit of phosphor of the present invention, and the values of proportions of numbers of atoms of respective elements constituting a phosphor of the present invention are normalized such that the summation of the values is defined to be one (1). In the phosphor of the present invention, Ce is an activating element and an emission wavelength and an emission intensity of the phosphor can be varied by controlling the atomic fraction a of Ce. An emission wavelength of a phosphor of the present invention can be controlled in a range of at least 560 nm and not exceeding 620 nm if the aforementioned range is satisfied. More specifically, within the aforementioned range, it is possible to shift the emission wavelength to a longer side (red shift) by increasing the atomic fraction a. That is, the phosphor of the present invention emits yellow light when the atomic fraction a is small, and the emission is shifted continuously to the longer side such that the phosphor emits orange light and then red light as the atomic fraction a is increased.

On the other hand, when the atomic fraction a is smaller than 0.0005, the shift of the emission wavelength of the phosphor as mentioned above may not be observed and the emission intensity of the phosphor may become too low since the enough emission efficiency of Ce may not be obtained because of too low concentration of Ce. And when the atomic fraction a is larger than 0.02, the shift of the emission wavelength of the phosphor as mentioned above also becomes hard to be observed and further the emission intensity of the phosphor may become too small because of concentration quenching caused by too high concentration of Ce. Thus, it is possible to tune up the wavelength as desired while keeping the high emission intensity by controlling the atomic fraction a within the predetermined range.

For example, within the above-mentioned ranged of the atomic fraction a, it is also possible to approximate the peak position (this may be a position of a midpoint of a peak width at 95% of the maximum peak intensity) by the following formula.

$$\text{Wavelength } (\lambda) = -2.445 \times 10^5 a^2 + 6.280 \times 10^3 a + 563 \quad \text{(Formula 1)}.$$

Thus, it is possible to provide a composition region of the phosphor in which a peak position in the wavelength is controlled by a simple index such as an atomic fraction of Ce and it is also possible to provide a series of phosphor group to emit spectra having various peak positions in the wavelength.

An atomic fraction b of Li in the phosphor of the present invention satisfies:

$$0.005 \leq b \leq 0.11 \ .$$

The emission efficiency of the phosphor of the present invention is improved by Li. The effect of improving the emission efficiency by Li may be too little when the atomic fraction b is smaller than 0.005 and the emission efficiency may deteriorate when the atomic fraction b is larger than 0.11 since the stability of the crystal structure of the host crystal is lowered.

An atomic fraction c of Ca in the phosphor of the present invention satisfies:

$$0.03 \leq c \leq 0.15 \ .$$

The emission efficiency may deteriorate when the atomic fraction c is off from the above range since the stability of the crystal structure of the host crystal is lowered. When the phosphor of the present invention further comprises Sr as described above, Sr is positioned at Ca site and works to make the emission wavelength shorter.

An atomic fraction d of Al in the phosphor of the present invention satisfies:

$$0.03 \leq d \leq 0.15 \ .$$

The emission efficiency may deteriorate when the atomic fraction d is off from the above range since the stability of the crystal structure of the host crystal is lowered.

An atomic fraction e of Si in the phosphor of the present invention satisfies:

$$0.2 \leq e \leq 0.3 \ .$$

The emission efficiency may deteriorate when the atomic fraction e is off from the above range since the stability of the crystal structure of the host crystal is lowered.

The phosphor of the present invention may include a metal element (thereinafter, referred to as X) other than Ce, Li, Ca (and Sr), Si and Al as mentioned above. In this case, an atomic fraction f of X in the phosphor of the present invention can be selected according to the application, but preferably satisfies:

$$f \leq 0.0001 \ .$$

The emission efficiency may deteriorate when the atomic fraction f is larger than 0.0001 since the stability of the crystal structure of the host crystal is lowered because element X is incorporated into the host crystal. The element X is, for example, one or more kinds of elements selected from Na, K, Sc, Y, La, Pr, Nd, Sm, Eu, Gd, Tb, Dy, Ho, Er, Tm, Yb, Lu, Cr, Mn, Cu, Zn, B, Ga, In, Ge, and Sn.

Among them, Na and K have an effect to change the emission wavelength by replacing part of Li with themselves. Sc, Y, La, and Lu have an effect to change the emission wavelength by replacing part of Ca with themselves. Pr, Nd, Sm, Eu, Gd, Tb, Dy, Ho, Er, Tm, Yb, Cr, Mn, and Cu exhibit performance of emission and works so as to change the emission color and the emission spectra by co-existing with Ce ion. In particular, when Eu is added, a red component of the emission of longer wavelength than 600 nm is increased so as to obtain a phosphor exhibiting a wider spectrum such that the phosphor is preferable for use in the white LED application.

Boron (B) is often contaminated from a container for firing phosphor and naturally introduced into the phosphor during an ordinary manufacturing process. And addition of a small amount of boron (B) to the phosphor has an effect on a decrease of crystal deffects in the crystal so as to increase an emission intensity. With respect to other metal elements, an adverse effect of the contamination of such elements on the emission is small as far as the contamination is small enough to keep an atomic fraction of f within the above-described range. Further, flux including element X can be added in order to control the particle size of the phosphor during a synthetic process and the emission of the phosphor is affected only a little by such contamination even the element X still remains in the phosphor as far as an amount thereof is withing the above-described range. The element having such a flux effect is, for example, B or Na.

An atomic fraction g of O in the phosphor of the present invention satisfies:

$$0.008 \leq g \leq 0.1 \ .$$

When the atomic fraction of g is less than 0.008, addition of oxygen has only a small effect on improving the emission efficiency, and the emission efficiency may deteriorate when the atomic fraction g is larger than 0.1 since the stability of the crystal structure of the host crystal is lowered.

An atomic fraction h of N in the phosphor of the present invention satisfies:

$$0.4 \leq h \leq 0.5 \ .$$

The emission efficiency may deteriorate when the atomic fraction h is off from the above range since the stability of the crystal structure of the host crystal is lowered.

It is not necessary for phosphors of the present invention to have the above-mentioned atomic fractions: a, b, c, d, e, f, g, and h that satisfy all of the above-described conditions, but it is preferable that the atomic fractions: a and b satisfy the above conditions at the same time. Thereby, phosphors of the present invention can have a well-controlled emission wavelenth caused by Ce and a high emission intensity casued by Li. More preferably, in addition to the atomic fractions of a and b, the atomic fraction of g may satisfy the above condition at the same time. Thereby, phosphors of the present invention can have a well-controlled emission wavelenth caused by Ce and a higher emission intensity casued by Li and oxygen.

Yet more preferably, phosphors of the present invention may have the atomic fractions: a, b, c, d, e, f, g, and h that satisfy all of the above-described conditions. In this case, the composition formula in the phosphor of the present invention is given by $Ce_aLi_bCa_cAl_dSi_eX_fO_gN_h$ (X is a metal element other than Ce, Li, Al, Si, and Ca (and Sr) in the formula. The values of a, b, c, d, e, f, g, and h are at least zero (0) and not exceeding one (1) to indicate fractions. And a+b+c+d+e+f+g+h=1.), and the atomic fractions: a, b, c, d, e, f, g, and h satisfy the following conditions.

$$0.0005 \leq a \leq 0.02 \ ,$$

$$0.005 \leq b \leq 0.11 \ ,$$

$$0.03 \leq c \leq 0.15 \ ,$$

$$0.03 \leq d \leq 0.15 \ ,$$

$$0.2 \leq e \leq 0.3 \ ,$$

$$f \leq 0.0001 \ ,$$

$$0.008 \leq g \leq 0.1 \ ,$$

and

$$0.4 \le h \le 0.5 \ ,$$

Thereby, phosphors of the present invention can emit fluorescence with a high intensity having a peak at a wavelength in the range of at least 560 nm and not exceeding 620 nm by irradiation of the excitation source. Here, if phosphors of the present invention further includes Sr, the atomic fraction of c is the total of an atomic fraction of Ca and an atomic fraction of Sr.

Here, it is also conceivable to add the equivalent amount of Li (monovalent) to the amount of Ce (trivalent) which replaces Ca (divalent) in $CaAlSiN_3$ such that the charge compensation may be achieved. However, the present inventor found an unexpected effect of improving the emission efficiency, which is different from the charge compensation, by increasing the contained amount of Li more than that of Ce in the composition including oxygen. In particular, by taking a closer look at the atomic fraction of a of Ce and the atomic fraction of b of Li, the emission efficiency is even improved if these fractions satisfy the following formula:

$$b \ge 1.2 \times a \ .$$

Further, by taking a closer look at the atomic fraction of d of Al and the atomic fraction of e of Si, the emission efficiency is even improved more if these fractions satisfy the following formula:

$$1.5 \le e/d \le 9 \ .$$

Further, by taking a closer look at the atomic fraction of g of O and the atomic fraction of h of N, the emission efficiency is even improved more if these fractions satisfy the following formula:

$$0.015 \le g/h \le 0.1 \ .$$

The host crystal of the phosphor of the present invention is preferably a crystal of $CaAlSiN_3$, $LiSi_2N_3$, $Si_2N_2O$, or a solid solution crystal thereof, or what has the same crystal structure as one of these crystals. The emission efficiency is improved as the crystal is stabilized by taking one of these crystal structures. For example, $CaAlSiN_3$, $LiSi_2N_3$, and a solid solution crystal thereof have a similar skeleton if a crystal phase of $Si_2N_2O$ (mineral name: Sinoite) is taken as a standard, and Si or Al occupies Si sites of the crystal phase of $Si_2N_2O$ and N occupies N and O sites thereof such that they are a crystal phase in which Ca is incorporated into a space of a skelton formed with Si-N-O and that atomic coordinates are slightly changed by such element substitutions.

$CaAlSiN_3$, $LiSi_2N_3$, and $Si_2N_2O$ have the same type of crystal structure (that is, the same crystal structure), and they are in a crystal system of an orthorhombic crystal or a monoclinic crystal and their skelton structures formed by bonds of "Si or Al" and "O or N" are similar (See Patent reference 2 for details. Patent reference 2 is herein incorporated by reference.). Therefore, solid solution between these crystals are readily formed such that the crystal stability is enhanced. As the crystal stability is enhanced, the phosphor durability is also enhanced such that the phosphor does not deteriorate so much for a long period of time. Further, the temperature property indicating a degree of deterioration of the emission intensity of the phosphor at a temperature in the range from 100 to 300 °C as compared to that of the phosphor at the room temperature is improved such that the temperature property of the LED element is improved. These crystal phases may be identified by conducting a Rietveld analysis with respect to the X-ray diffraction measurement data. For example, the $CaAlSiN_3$ crystal itself belongs to a space group of $Cmc2_1$ or $P2_1$ and is in the orthorhombic crystal system such that the lattice constants are as follows: a=9.8007(4) A, b=5.6497(2) Å, and c=5.0627(2) Å. The features of such a crystal are summarized in Table 6 (cited from Patent reference 2) as described later.

In the following, the difference between the present invention and what is described in Patent reference 1, Patent reference 2, and Non-patent reference 1 put in the public domain will be described.

First, Example 86 of Patent reference 1 discloses the fluorescence at 616 nm is emitted by the crystal having the same crystal structure as $CaAlSiN_3$ if Ce is added to the crystal. However, Patent reference 1 does not disclose the phosphor having a composition including lithium and oxygen at the same time, and thus the influence of the lithium in the $CaAlSiN_3$ group crystal is not taught or suggested.

On the other hand, Patent reference 2 teaches the crystal having the same crystal structure as $CaAlSiN_3$ can become a phosphor and addition of Ce thereto causes the phosphor to emit. Further, Patent reference 2 discloses the

phoshpor: $(Ce_yCa_{1-y-z}AlSiN_3)_{1-x}(LiSi_2N_3)$, to be obtained by firing a mixture of celium nitride, calcium nitride, lithium nitride, silicon nitride, and aluminum nitride powders as a starting raw material in an innert atmosphere including nitrogen in a temperature range of at least 1200 °C and not exceeding 2200 °C. It discloses that the phosphor $(Ca_{0.2}Sr_{0.7925}Ce_{0.0075}AlSiN_3)_{0.61}(LiSi_2N_3)_{0.39}$ was obtained by firing at 1250 °C a mixture of silicon nitride ($Si_3N_4$), lithium nitride ($Li_3N$), and $(Ca_{0.2}Sr_{0.7925}Ce_{0.0075})AlSiN_3$ phosphor having been synthesized by firing and nitriding $(Ca_{0.2}Sr_{0.7925}Ce_{0.0075})AlSi$ metal alloy in a nitrogen atmosphere of 190 MPa at 1900 °C in Example IV-1. And it discloses that the phosphor exhibited higher emission intensity than that of $Ca_{0.2}Sr_{0.7925}Ce_{0.0075}AlSiN_3$.

However, the phosphor of Example IV-1 is a phosphor that does not substantially include oxygen and no suggestions are made about what kind of effects could be provided if lithium (Li) and oxygen (O) are included at the same time. In particular, it neither discloses nor suggests any effects on the peak position (wavelength) and the emission intensity of the emission spectrum, which are important features of the phosphor.

Further, Patent reference 2 discloses phosphors in which Ca of $CaAlSiN_3$ is partially substituted with an alkali metal and N of $CaAlSiN_3$ is partially substituted with oxygen. As a phosphor including Ce, $(Ce_yM^{II}AlSiN_3)_{1-x}(Si_2N_2O)_x$, which is a mixture composition of $CaAlSiN_3$ and $Si_2N_2O$, wherein $M^{II}$ is an alkaline-earth element and $0 \leq x \leq 0.45$ and $0 < y \leq 0.2$, is disclosed in Patent reference 2. Further, it discloses phosphors having compositions in which x = 0.18 and y = 0.026-0.04, as examples of such a mixture composition, exhibit emissions at a wavelength range from 576 to 587 nm.

However, it cannot be conceivable that there are effects of improving the emission efficiency and controlling the emission wavelength because the system does not contain lithium element. That is, a so-called synergetic action of lithium element and oxygen element is not disclosed such that an unexpected effect such as shift of an emission wavelength is even unforeseeable. Therefore, the present invention according to the present application could not have been readily conceivable over patent references 1 and 2.

Further, the phosphor according to the present invention has a different composition other than that of $CaAlSiN_3$: $Ce^{3+}$ including Li as disclosed in Non-patent reference 1. In Non-patent reference 1, the same amount of Li as $Ce^{3+}$ for the purpose of charge compensation of $Ce^{3+}$ was added. To the contrary, according to the present invention, most of Ca in the $CaAlSiN_3$ crystal is substitued with Li and this is because more than 1.2 times as much amount of Ca as Ce is substitued with Li. And even Non-patent reference 1 does not disclose any compositions including both oxygen and lithium.

In the pesent invention, after the relationship between the composition range of the phosphor and the emission wavelength or the emission efficiency were investigated with respect to phosphors including Ce and Li and oxygen and having a $CaAlSiN_3$ group crystal as a host crystal, a new invention was conceived such that inventions of Patent reference 1 and Patent reference 2 are to be other selective inventions having different composition limit ranges.

Next, phosphors to emit fluorescence having a desired color and a peak position in the wavelength range of at least 560 nm and not exceeding 620 nm, as the above-mentioned composition control is conducted for the phosphors, will be described in detail.

(i) Yellow Phosphor

As a phosphor of the present invention, the following phosphors are provided to emit yellow fluorescence by controlling their compositions. That is, an atomic fraction of a of Ce, an atomic fraction of b of Li, an atomic fraction of c of Ca, an atomic fraction of d of Al, an atomic fraction of e of Si, an atomic fraction of f of metal element other than Ce, Li, Ca, Si and Al, an atomic fraction of g of O, and an atomic fraction of h of N satisfy the following conditions:

$$0.0007 \leq a \leq 0.01 ,$$

$$0.005 \leq b \leq 0.11 ,$$

$$0.03 \leq c \leq 0.15 ,$$

$$0.03 \leq d \leq 0.15 ,$$

$$0.2 \leq e \leq 0.3 \ ,$$

$$f \leq 0.0001 \ ,$$

$$0.008 \leq g \leq 0.1 \ ,$$

and

$$0.4 \leq h \leq 0.5,$$

so as to provide a phosphor to emit yellow fluorescence having a peak at a wavelength in a range of at least 560 nm and less than 580 nm by irradiation of an excitation source. When the atomic fractions are out of the above ranges, it is difficult to obtain a phosphor to emit fluorescence having a peak at a wavelength in the range of at least 560 nm and less than 580 nm with a high emission efficiency. Here, if a phosphor of the present invention further includes Sr, the atomic fraction of c is the total of an atomic fraction of Ca and an atomic fraction of Sr.

(ii) Orange Phosphor

As a phosphor of the present invention, the following phosphors are provided to emit orange fluorescence by controlling their compositions. That is, an atomic fraction of a of Ce, an atomic fraction of b of Li, an atomic fraction of c of Ca, an atomic fraction of d of Al, an atomic fraction of e of Si, an atomic fraction of f of metal element other than Ce, Li, Ca, Si and Al, an atomic fraction of g of O, and an atomic fraction of h of N satisfy the following conditions:

$$0.0019 \leq a \leq 0.0085 \ ,$$

$$0.005 \leq b \leq 0.11 \ ,$$

$$0.03 \leq c \leq 0.15 \ ,$$

$$0.03 \leq d \leq 0.15 \ ,$$

$$0.2 \leq e \leq 0.3 \ ,$$

$$f \leq 0.0001 \ ,$$

$$0.008 \leq g \leq 0.1 \ ,$$

and

$$0.4 \leq h \leq 0.5,$$

so as to provide a phosphor to emit orange fluorescence having a peak at a wavelength in a range of at least 580 nm and less than 600 nm by irradiation of an excitation source. When the atomic fractions are out of the above ranges, it is difficult to obtain a phosphor to emit fluorescence having a peak at a wavelength in the range of at least 580 nm and less than 600 nm with a high emission efficiency. In particular, it is preferable that the atomic fraction of b, the atomic fraction of c, the atomic fraction of d, the atomic fraction of e, the atomic fraction of g, and the atomic fraction of h satisfy the following conditions:

$$0.03 \leq b \leq 0.11 \; ,$$

$$0.04 \leq c \leq 0.12 \; ,$$

$$0.04 \leq d \leq 0.12 \; ,$$

$$0.21 \leq e \leq 0.3 \; ,$$

$$0.015 \leq g \leq 0.05 \; ,$$

and

$$0.45 \leq h \leq 0.5,$$

so as to provide a phosphor to emit orange fluorescence with higher emission efficiency. These atomic fractions affect both emission wavelength and emission efficiency such that a phosphor to emit fluorescence in a desired color with a high emission efficiency can be obtained by controlling these atomic fractions. Here, if a phosphor of the present invention further includes Sr, the atomic fraction of c is the total of an atomic fraction of Ca and an atomic fraction of Sr.

(iii) Red Phosphor

As a phosphor of the present invention, the following phosphors are provided to emit red fluorescence by controlling their compositions. That is, an atomic fraction of a of Ce, an atomic fraction of b of Li, an atomic fraction of c of Ca, an atomic fraction of d of Al, an atomic fraction of e of Si, an atomic fraction of f of metal element other than Ce, Li, Ca, Si and Al, an atomic fraction of g of O, and an atomic fraction of h of N satisfy the following conditions:

$$0.006 \leq a \leq 0.018 \; ,$$

$$0.005 \leq b \leq 0.11 \; ,$$

$$0.03 \leq c \leq 0.15 \; ,$$

$$0.03 \leq d \leq 0.15 \; ,$$

$$0.2 \leq e \leq 0.3 \; ,$$

$$f \leq 0.0001 \; ,$$

$$0.008 \leq g \leq 0.1 \; ,$$

and

$$0.4 \leq h \leq 0.5,$$

so as to provide a phosphor to emit red fluorescence having a peak at a wavelength in a range of at least 600 nm and less than 620 nm by irradiation of an excitation source. When the atomic fractions are out of the above ranges, it is difficult to obtain a phosphor to emit fluorescence having a peak at a wavelength in the range of at least 600 nm and less than 620 nm with a high emission efficiency. In particular, it is preferable that the atomic fraction of b, the atomic fraction of c, the atomic fraction of d, and the atomic fraction of g satisfy the following conditions:

$$0.016 \leq b \leq 0.04 \; ,$$

$$0.06 \leq c \leq 0.13 \; ,$$

$$0.06 \leq d \leq 0.13 \; ,$$

and

$$0.015 \leq g \leq 0.05 \; ,$$

so as to provide a phosphor to emit red fluorescence with higher emission efficiency. These atomic fractions affect both emission wavelength and emission efficiency such that a phosphor to emit fluorescence in a desired color with a high emission efficiency can be obtained by controlling these atomic fractions. Here, if a phosphor of the present invention further includes Sr, the atomic fraction of c is the total of an atomic fraction of Ca and an atomic fraction of Sr.

As described above in detail, it is possible to provide a phosphor to emit yellow fluorescence (at least 560 nm and less than 580 nm in the wavelength), orange fluorescence (at least 580 nm and less than 600 nm in the wavelength), or red fluorescence (at least 600 nm and not exceeding 620 nm in the wavelength) by controlling each atomic fraction of each constituent element within a specific composition range even though the same kinds of constituent elements constitute the phosphor of the present invention.

Next, a composition of a host crystal of a phosphor of the present invention will be described in detail. The host crystal of the phosphor of the present invention is a $CaAlSiN_3$ group crystal, as described above, and is specifically selected from a group consisting of $CaAlSiN_3$, $LiSi_2N_3$, $Si_2N_2O$, and a solid solution crystal thereof, and a crystal having an identical crystal structure to any one of thus-mentioned crystals.

As a composition of a typical host crystal of the present invention, a composition may be designed to be a mixture of any inorganic materials selected from a group consisting of $LiSi_2N_3$, $CaAlSiN_3$, $SrAlSiN_3$, and $Si_2N_2O$. Here, mixture fractions of these inorganic materials may be given by the formula: $x_1 LiSi_2N_3 + x_2 CaAlSiN_3 + x_3 SrAlSiN_3 + x_4 Si_2N_2O$ ($x_1$, $x_2$, $x_3$, and $x_4$ are numerial values at least zero (0) and not exceeding one (1) to indicate fractions, and $x_1+x_2+x_3+x_4=1$.) The parameters $x_1$, $x_2$, $x_3$, and $x_4$ satisfy the following conditions:

$$0.02 \leq x_1 \leq 0.80 \; ,$$

$$0.20 \leq x_2 + x_3 \leq 0.80 ,$$

and

$$0.04 \leq x_4 \leq 0.30 .$$

A typical phosphor of the present invention may be provided by adding Ce to the composition of this host crystal such that a resultant composition of the phosphor may satisfy the above composition formula. When a mixture of raw materials mixed to become the resultant compossition is heat-treated, a phosphor in which a solid solution of inorganic crystals selected from a group consisting of $LiSi_2N_3$, $CaAlSiN_3$, $SrAlSiN_3$, and $Si_2N_2O$ is activated with Ce is formed such that the phosphor with a high emission efficiency may be obtained.

In particular, the phosphor having a solid solution of a $CaAlSiN_3$ crystal including Li and O:

$$x_1 LiSi_2N_3 + x_2 CaAlSiN_3 + x_4 Si_2N_2O,$$

or

$$x_1 LiSi_2N_3 + x_2 CaAlSiN_3 + x_3 SrAlSiN_3 + x_4 Si_2N_2O$$

shows a high emission efficiency.

In the present invention, it is preferable that the phosphor includes, as much as possible with high purity, a $CaAlSiN_3$ group crystal, that is, $CaAlSiN_3$, $LiSi_2N_3$, and $Si_2N_2O$, and a solid solution crystal thereof, or a single phase crystal having the same crystal structure as any one of them, in view of emission properties, but the phosphor may be a mixture with another crystal phase other than the above-mentioned crystal phase and/or an amorphous phase as far as the properties of the phosphor may not deteriorate. In this case, it is preferable that the content of the $CaAlSiN_3$ group crystal is 20 mass% or more in order to achieve the high brightness of the phosphor. More preferably, when the content of the $CaAlSiN_3$ group crystal is 50 mass% or more, the brightness of the phosphor is improved remarkably. Here, content fractions of crystal phases in the phosphor can be determined by the Rietveld analysis as the X-ray diffraction measurement is conducted. As a simplified method, the content fractions may be obtained by ratios of the strongest peaks of respective crystal phases.

Although the method of manufacturing the phosphor of the present invention is not prescribed, a phosphor having high brightness can be manufactured by the following method.

A phosphor of high brigntness according to the present invention can be obtained by firing a raw material mixture including at least Ce, Li, Ca, Si, Al, and N (and Sr and/or O if necessary), the mixture being comprised of metal compounds, in a nitrogen atmosphere in a temperature range from $15 \times 10^2$ °C to $22 \times 10^2$ °C.

The raw material mixture is designed to have an atomic fraction of a of Ce, an atomic fraction of b of Li, an atomic fraction of c of Ca (atomic fraction of a mixture of Ca and Sr if Sr is contained), an atomic fraction of d of Al, an atomic fraction of e of Si, an atomic fraction of f of metal element other than Ce, Li, Ca, Si and Al, an atomic fraction of g of O, and an atomic fraction of h of N satisfy the following conditions:

$$0.0005 \leq a \leq 0.02 ,$$

$$0.005 \leq b \leq 0.11 ,$$

$$0.03 \leq c \leq 0.15 ,$$

$$0.03 \leq d \leq 0.15 \ ,$$

$$0.2 \leq e \leq 0.3 \ ,$$

$$f \leq 0.0001 \ ,$$

$$0.008 \leq g \leq 0.1 \ ,$$

and

$$0.4 \leq h \leq 0.5,$$

so as to provide a phosphor to emit fluorescence having a peak at a wavelength in a range of at least 560 nm and not exceeding 620 nm by irradiation of an excitation source.

Further, the raw material mixture is designed such that the host crystal of the phosphor has a composition given by the formula: $x_1LiSi_2N_3 + x_2CaAlSiN_3 + x_3SrAlSiN_3 + x_4Si_2N_2O$ ($x_1$, $x_2$, $x_3$, and $x_4$ are numerial values at least zero (0) and not exceeding one (1) to indicate fractions, and $x_1+x_2+x_3+x_4=1$.) and the parameters $x_1$, $x_2$, $x_3$, and $x_4$ satisfy the following conditions:

$$0.02 \leq x_1 \leq 0.80 \ ,$$

$$0.20 \leq x_2 + x_3 \leq 0.80 \ ,$$

and

$$0.04 \leq x_4 \leq 0.30 \ .$$

Thereby, the obtained composition of the host crystal of the phosphor is a mixture of inorganic materials selected from a group consisting of $LiSi_2N_3$, $CaAlSiN_3$, $SrAlSiN_3$, and $Si_2N_2O$ as mentioned above.

As a Ce source, metal cerium, cerium nitride, cerium oxide, cerium silicide, cerium hydride, and so on may be used and, in particular, lithium nitride may be used In order to obtain a phosphor havingin a composition with high content of Ce and high content of nitrogen. When a phosphor with low content of Ce is to be obtained, cerium oxide, which is available for a low cost, can be used.

As a Li source, metal lithium, lithium nitride, lithium carbonate, lithium silicide, lithium hydride, and so on may be used and, in particular, lithium nitride may be used in order to obtain a phosphor havingin a composition with high content of nitrogen.

As a Ca source, metal Ca, calcium nitride, calcium carbonate, calcium oxide, calcium hydride, and so on may be used and, in particular, it is good to use calucium nitride in order to obtain a phosphor havingin a composition with high content of nitrogen. When a phosphor with low content of Ca and high content of oxygen is to be obtained, calcium carbonate or calcium oxide, which is available for a low cost, can be used. Here, when a phosphor including Sr is obtained, strontium nitride, strontium carbonate, and strontium oxide can be used.

As a Si source, metal silicon, silicon nitride, silicon oxide, metal silicide, silicon imide, and so on can be used, and, in particular, it is good to use silicon nitride in order to obtain a phosphor having a composition with high content of nitrogen. And as a source of oxygen in the composition, silicon oxide may also be used.

As a Al source, metal aluminum, aluminum nitride, aluminum oxide, aluminum hydroxide, aluminum silicide, and so on can be used, and, in particular, it is good to use aluminum nitride in order to obtain a phosphor having a composition with high content of nitrogen. And as a source of oxygen in the composition, aluminum oxide may also be used.

Among these raw materials, as reactive raw materials to produce a good phosphor, cerium oxide, lithium nitride, calcium nitride, silicon nitride, aluminum nitride, and, if necessary, silicon oxide and aluminum oxide may be used.

Since it is likely to obtain a stable crystal and a phosphor of high brightness, it is preferable that the firing is conducted in a nitrogen atmosphere of a pressure range of 0.1 MPa or higher and 100 MPa or lower. It is likely that silicon nitride as a raw material is readily decomposed at a high firing temperature when the gas pressure is less than 0.1 MPa. And the gas pressure higher than 100 MPa leads to high cost such that it is not preferable in view of the industrial productivity.

The raw material mixture of the above metal compounds is in a powder state, and it is good to fire such mixture in a condition that the bulk density of the mixture is kept at 40% or less. The bulk density refers to the volume packing fraction of powder and is a value given by dividing the ratio of mass of the powder filled in a certain vessel to the volumetric capacity of the vessel by the theoretical density of the metal compounds. Since the reactivity of a boron nitride sintered compact is low with the metal compounds, the boron nitride sintered compact is suitable for the vessel. In this case, a small amount of boron may be taken into the sample from the boron nitride vessel, but the fluorescence properties of the phosphor would hardly deteriorate as far as the atomic fraction of metal element other than Ce, Li, Ca, Sr, Si and Al is 0.0001 or less.

The reason why the firing process is conducted as the bulk density is kept to be 40 % or less is that it is readily to synthesize crystals with a small amount of surface defects since contacts between crystals become less as the crystals grow with reaction products if the firing process is conducted in a state where more free space is provided around the raw material powder.

Next, the phosphor of the present invention is synthesized by firing the thus-obtained mixture of the metal compounds in an inert atmosphere containing nitrogen in a temperature range of $15 \times 10^2$ °C or higher and $22 \times 10^2$ °C or lower. Since the firing temperature is high and the firing atmosphere is an inert atmosphere containing nitrogen, an electric furnace of a metal resistance heating type or a graphite resistance heating type, in which a high temperature member of the furnace made of carbon is used, is suitable. As the firing method, a sintering method such as a pressureless sintering method or a gas-pressure sintering method in which no mechanical pressure is applied from the outside is preferable, but not a hot-press method, when the raw material powder is directly synthesized since it is possible to conduct the firing as the bulk density is kept low in such a method.

When an aggregate obtained by the firing is firmly solidified, the powder aggregate is milled by a pulverizer usually used in the industry such as a ball mill and a jet mill. Grinding is continued until an averaged particle diameter of 50 μm or smaller is reached. Preferably, Grinding is continued until the mean particle diameter becomes 0.1 μm to 5 μm. If the mean particle diameter exceeds 50 μm, the fluidity of the powder and the dispersibility of the powder to resin tend to be inferior. Consequently, when a light emitting device is made by combining a light-emitting element, the emission intensity tends to become nonuniform depending on a portion of the element. If the mean particle diameter is smaller than 0.1 μm, the number of defects on the phosphor powder surface increases such that the emission intensity is lowered depending on the composition of the phosphor.

If the phosphor powder after firing, the phosphor powder after milling treatment, or the phosphor powder after particle size adjustment is heat-treated in a temperature range of 1000 °C or higher and equal to or lower than the firing temperature, the defects introduced on the surface at the time of milling and the like decrease such that the brightness is improved.

By washing the sintered phosphor with water or a solvent constituted of an aqueous solution of an acid, the content of a glass phase, a secondary phase, or an impurity phase contained in the product can be reduced, and the brightness is enhanced. In this case, the acid can be selected from one kind of substance or a mixture of sulfuric acid, hydrochloric acid, nitric acid, hydrofluoric acid, and organic acid. In particular, a mixture of hydrofluoric acid and sulfuric acid shows a pronounced effect on removing impurities.

If the phosphor of the present invention is used in a powder state, it is preferable that the mean particle diameter is from 0.1 μm to 50 μm in consideration of dispersibility into a resin and fluidity of the substance in a powder state. In particular, a particle diameter of 5μm or larger and 10 μm or smaller is excellently handleable. Further, the emission intensity is increased if the phosphor in a powder state comprises single crystal particles with the mean diameter of 5 μm or larger and 10 μm or smaller.

In order to obtain a phosphor with high emission intensity, it is preferable that the content of impurities included in the inorganic compound is minimized. In particular, since light emission is inhibited if a large amount of impurity elements such as Fe, Co, and Ni is contained, it is desirable to select the raw material powders and control a synthesis process such that the total amount of these elements is 500 ppm or smaller.

It is possible to provide the electrical conductivity to the phosphor of the present invention by mixing inorganic substances having the electrical conductivity into the phosphor if the phosphor is applied to the field where the phosphor is excited by an electron beam. As the inorganic substance having the electrical conductivity, oxide, oxynitride, nitride, or a combination thereof, which include one or more kinds of elements selected from Zn, Al, Ga, In, and Sn, can be referred to.

The phosphor of the present invention emits fluorescence of a specific color of the wavelength region of at least 560 nm and not exceeding 620 nm. If it is necessary to mix the specific color with other colors, it is possible to mix it with other inorganic phosphors which emit fluorescence of the other colors.

The phosphor of the present invention emits fluorescence which has a peak in the wavelength region of at least 560 nm and not exceeding 620 nm when irradiated by an excitation source. The light of this wavelength region corresponds to respective colors of yellow, orange, and red such that the wavelength may be selected in accordance with the purpose of use, and then a composition of the phosphor to emit light of the selected wavelength may be synthesized.

The excitation source is, by way of example, light having a wavelength in a range of at least 100 nm and not exceeding 500 nm (a vacuum ultraviolet radiation ray, an ultraviolet ray, or visible light), and radiation such as an electron beam, an X-ray, a neutron beam, and so on. Further, the phosphor may also be utilized for excitation (inorganic EL device) in the electric field.

As explained above, since the phosphor of the present invention exhibits high brightness and is chemically stable, the brightness of the phosphor only slightly deteriorates even when the phosphor is exposed to the excitation source. And the phosphor is suitable for a VFD, an FED, a PDP, a CRT, a white color LED, and the like and, in particular, is suitable for the white color LED if it is combined with a blue color LED.

The light-emitting device of the present invention is configured with at least an emission source and the phosphor (hereinafter referred to as first phosphor) of the present invention. As the light-emitting device, there are an LED emission apparatus, an electroluminescence (EL) emission apparatus, a fluorescent lamp, and so on. The LED emission device can be manufactured by utilizing the first phosphor with a publicly known method which is described in Japanese Patent Application Publication No. H05-152609, Japanese Patent Application Publication No. H07-99345, Japanese Patent No. 2927279, and so on. In this case, the light source is preferably what emits light of a wavelength in the region from 330 nm to 500 nm and, in particular, an LED light-emitting element emitting an ultraviolet (or violet) ray of a wavelength in the region of at least 330 nm and not exceeding 430 nm, or a blue LED light-emitting element emitting light of a wavelength in the region of at least 430 and not exceeding 480 nm is preferred. Such LED light-emitting elements include a nitride semiconductor such as GaN or InGaN, which can be an emission source of a predetermined wavelength by adjusting the composition.

In such light-emitting devices, in addition to the first phosphor, the device may include at least one phosphor selected from a group consisting of β-sialon green phosphor activated with Eu, α-sialon yellow phosphor activated with Eu, $Sr_2Si_5N_8$ orange phosphor activated with Eu, (Ca, Sr)AlSiN$_3$ orange phosphor activated with Eu, and CaAlSiN$_3$ red phosphor activated with Eu. As the yellow phosphor other than the above, for example, YAG:Ce. (Ca, Sr, Ba)Si$_2$O$_2$N$_2$: Eu and the like may be used.

According to the present invention, it is possible to synthesize a yellow emitting phosphor of a wavelength in the range of at least 560 nm and less than 580 nm, an orange emitting phosphor of a wavelength in the range of at least 580 nm and less than 600 nm, and a red emitting phosphor of a wavelength in the range of at least 600 nm and not exceeding 620 nm by selecting compositions, and thereby it is possible to provide a yellow, an orange, and a red light emitting elements by combining these phosphors (first phosphor) and the ultraviolet LED emitting element of a wavelength in the range of at leasst 330 nm and less than 430 nm.

Also, it is possible to provide light-emitting elements of daylight color, natural white color, white color, warm white color, and incandescent color as white LED having different color temperatures can be provided by combining the yellow or orange phosphor (first phosphor) of the present invention with a blue LED emitting element to emit light of the wavelength of at least 430 nm and not exceeding 480 nm.

In the light-emitting device, it is possible to configure a light-emitting device to emit light of desired color not only by utilizing the first phosphor by itself, but also by combining other phosphors having other light emitting properties with the first phosphor. As one of these examples, if an LED or LD to emit light of a wavelength in the range of at least 330 nm and less than 430 nm, a first phosphor to emit orange or yellow light, a blue phosphor (second phosphor) having an emission peak at a wavelength in the range of at least 430 nm and not exceeding 480 nm as being excited by excitation light in the range of at least 330 nm and less than 430 nm, and, as necessary, a red phosphor (third phosphor) having an emission peak at a wavelength in the range of at least 600 nm and not exceeding 700 nm as being excited by excitation light in the range of at least 330 nm and less than 430 nm are utilized, it is possible to provide a light-emitting device to emit white color light by mixing blue color light emitted by the second phosphor, orange color light or yellow color light emitted by the phosphor of the present invention, and, as necessary, red color light emitted by the third phosphor.

Here, a phosphor of the present invention to emit red light having a peak at a wavelength in the region of at least 600 nm and not exceeding 620 nm may be utilized as the third phosphor. Further, a cyan phosphor to emit fluorescence having an emission peak at a wavelength in the range of at least 480 nm and less than 520 nm by excitation light in the range of at least 330 nm and less than 430 nm and/or a green phosphor to emit fluorescence having an emission peak at a wavelength in the range of at least 520 nm and less than 560 nm by excitation light in the range of at least 330 nm and less than 430 nm may be utilized in addition to part or all of the above-mentioned first to third phosphors. The combination of such phosphors may be designed as appropriate depending on the color temperature necessary for the white color light to be emitted by the light-emitting device.

In an alternative way, if the light source is an LED or an LD to emit blue light in the wavelength range of at least 430 nm and not exceeding 480 nm, and if the first phosphor, and, as necessry, a green phosphor (fourth phosphor) emitting light having an emission peak at a wavelength in the range of at least 520 nm and less than 560 nm by excitation light in the range of at least 430 nm and not exceeding 480 nm, and, as necessry, a red phosphor (fifth phosphor) emitting light having an emission peak at a wavelength in the range of at least 600 nm and not exceeding 700 nm by excitation light in the range of at least 430 nm and not exceeding 480 nm are utilized, it is possible to provide a light-emitting device to emit white color light by mixing blue color light of the excitation light source, yellow or orange color light emitted by the first phosphor, and, as necessary, green light emitted by the fourth phosphor, and, as necessary, red light emitted by the fifth phosphor. Here, a phosphor of the present inventon to emit red fluorescence having a peak at a wavelength in the range of at least 600 nm and not exceeding 620 nm can also be utilized as the fifth phosphor. Further, a cyan phosphor to emit fluorescence having an emission peak at a wavelength in the range of longer than 480 nm and shorter than 520 nm by excitation light in the range of at least 430 nm and not exceeding 480 nm may be utilized in addition to part or all of the above first phosphor, the fourth phosphor, and fifth phosphor.

In the light-emitting device of the present invention, it is possible to utilize other phosphors by combining the other phosphors with the phosphors of the present invention. As examples of such other phosphors, the following phosphors of oxide, sulfide, nitride, oxynitride groups may be referred to.

As a red color phosphor and a orange color phosphor, for example, $(Mg, Ca, Sr, Ba)_2Si_5N_8$: Eu, $(Y, La, Gd, Lu)_2O_2S$: Eu, $(Ca, Sr)AlSiN_3$: Eu, and the like may be referred to.

As a green color phosphor, for example, $\beta$-sialon: Eu, $(Ba, Sr, Ca, Mg)_2SiO_4$: Eu, $(Ca, Sr, Ba)Si_2O_2N_2$: Eu, and the like may be referred to.

As a blue color phosphor, for example, AIN: Eu, Si, $BaMgAl_{10}O_{17}$: Eu, $\alpha$-sialon: Ce, JEM: Ce, and the like may be referred to.

The image display device of the present invention is constituted of at least an excitation source and the phosphor of the present invention and includes a vacuum fluorescent display (VFD), a field emission display (FED), a plasma display panel (PDP), a cathode-ray tube (CRT), and the like. It has been confirmed that the phosphor of the present invention emits light by excitation of a vacuum ultraviolet ray of 100 to 190 nm, an ultraviolet ray of 190 to 380 nm, an electron beam, or the like, and the above image display devices can be configured by combining these excitation sources and the phosphors of the present invention.

Example

The present invention will be described in more detail with reference to the examples to be shown below, but these examples are disclosed only for the purpose of facilitating understanding the present invention readily such that the present invention is not limited to these examples.

[Examples 1-31]

As phosphors of the present invention, phosphors in Examples 1 to 14 were synthesized by controlling their compositions in order to emit yellow light; phosphors in Examples 15 to 28 were synthesized by controlling their compositions in order to emit orange light; and phosphors in Examples 29 to 31 were synthesized by controlling their compositions in order to emit red light.

In inorganic compounds: $Ce_aLi_bAl_cSi_eX_fO_gN_h$ (A is Ca by itself or a combination of Ca and Sr; X is metal element other than Ce, Li, Al, Si and A; and a+b+c+d+e+f+g+h=1 in the formula) including Ce, Li, Ca (and Sr), Al, Si, oxygen, and nitrogen, the compositions with the design parameters (atomic fractions): a, b, c, d, e, f, g, and h as shown in Table 1 were examined; and in inorganic compounds: $Ce + x_1LiSi_2N_3 + x_2CaAlSiN_3 + x_3SrAlSiN_3 + x_4Si_2N_2O$ ($x_1$, $x_2$, $x_3$, and $x_4$ are numerical values of at least zero (0) and not exceeding one (1) to indicate fractions; and $x_1 + x_2 + x_3 + x_4 = 1$ in the formula), the compositions with the design parameters: $x_1$, $x_2$, $x_3$, and $x_4$, as shown in Table 2 were examined. Here, it is assumed f=0 in the present examples. Based on these designs, powder materials of $Si_3N_4$, AIN, $Al_2O_3$, $Li_3N$, $Ca_3N_2$, $Sr_3N_2$, and $CeO_2$ were mixed according the compositions as shown in Table 3.

Here, in Table 2, it is apparently designed that Ce is incorporated into a crystal of the composition: $x_1LiSi_2N_3 + x_2CaAlSiN_3 + x_3SiAlSiN_3 + x_4Si_2N_2O$, but $CeO_2$ was employed as a source of Ce in mixing raw materials. It is plausible that Ce of the added $CeO_2$ replaced Ca at the position in the crystal so as to be solid solved and that oxygen of $CeO_2$ and replaced Ca were segregated from the crystal as a small amount of impurities so as to form a secondary phase or vaporize to dissipate in the ambient gas phase. That is, a crystal having the composition: $x_1LiSi_2N_3 + x_2CaAlSiN_3 + x_3SrAlSiN_3 + x_4Si_2N_2O$, in which Ca at the position in the crystal is replaced with Ce, is to be generated in accordance with the designs of Table 2.

Raw material powders were silicon nitride powder having a particle size of a specific surface area of 11.2 $m^2$/g, containing 1.29 wt% of oxygen, and containing 95 % $\alpha$-type silicon nitride (SN-E10 grade manufactured by Ube Industries, Ltd.); aluminum nitride powder having a particle size of a specific surface area of 3.3 m$^2$/g, containing 0.85 wt% of oxygen (F grade manufactured by Tokuyama Corporation); aluminum oxide powder having a particle size of a specific surface area of 13.2 m$^2$/g (Taimicron manufactured by Taimei Chemicals Co., Ltd.); lithium nitride powder (Li$_3$N; manufactured by Kojundo Chemical Laboratory Co., Ltd.); calcium nitride (Ca$_3$N$_2$) ; strontium nitride (Sr$_3$N$_2$) having been manufactured by nitriding metal strontium in an amonia at 800 °C; and cerium oxide (CeO$_2$; purity 99.9 %, manufactured by Shin-Etsu Chemical Co., Ltd.). These raw materials were designed to have the compositions of the host crystals summarized in Table 2 such that the atomic fractions listed in Table 1 may be satisfied and the raw material compositions summarized in Table 3 were mixed. These powder raw materials were weighed in a glove box in which a nitrogen ambient atmosphere was prepared with 1 ppm or less of oxygen and moisture such that the mixture compositions summarized in Table 3 were achieved, and mixing was continued for 10 minutes with an agate mortar and an agate pestle and then the resultant mixtures were passed through a 500 $\mu$m sieve and allowed fall naturally into a boron nitride crusible to fill the crucible with the powder. The bulk density of the powder was about 25% to 30%.

The crucible containing the powder mixture was set into an electric furnace of a graphite resistance heating type. In firing, first the firing atmosphere was made vacuum of 10$^{-3}$ Pa with a diffusion pump, and heated from room temperature to 800 °C at a rate of 500 °C per hour. Nitrogen of 99.999% purity by volume was introduced at 800 °C to raise the pressure to 1 MPa, and the temperature was further raised to a firing temperature at a rate of 500 °C per hour. The reached temperature was kept constant for 2 hours. Here, the firing temperature was 1700 °C for Examples 15 and 16, 1800 °C for Examples 1, 2, 5-14, and 17-31, and 1900 °C for Examples 3 and 4.

Next, the synthesized compounds were ground using an agate mortar, and powder X-ray diffraction measurements were conducted with the Cu K$_\alpha$ ray. Results of the X-ray diffraction measurements of Examples 2 and 29 are shown in Figs. 1 and 2, and will be described later.

These chemical compounds were examined by the wet chemical analysis. The analysis was conducted for Ca, Al, Si, Ce, and N among the compounds. For the analyses of Ca, Al, Si, and Ce, each compound of 30 mg was mixed with sodium carbonate of 0.75 g and boric acid of 0.3 g and heated to melt. After leaving the melt for cooling, it was dissolved with 3 ml of hydrochloric acid and pure water to be made 100 ml of solution. After the solution was diluted 10-fold, the diluted sample was measured with an ICP atomic emission spectrometer with respect to luminescence intensity of each element. A calibration curve method was employed and each concentration (wt%) was calculated from the measurement results. As to the analysis of N, 10 mg of each compound was weighed and put into a tin capsule, then the capsuled sample was moved into a nickel basket. This was loaded into an oxygen nitrogen analyzer and nitrogen gas generated therefrom was detected by a thermal conductivity detector such that the nitrogen was quantitatively measured to obtain a concentration (wt%) thereof. The results are summarized in Table 4 and will be described later.

After this compound was crushed coarsely, it was further ground by hand using a crucible and mortar made of a silicon nitride sintered compact, and then the sample was allowed to pass a 30 $\mu$m-mesh sieve. When the particle size distribution was measured, the mean particle diameter was 5 to 8 $\mu$m.

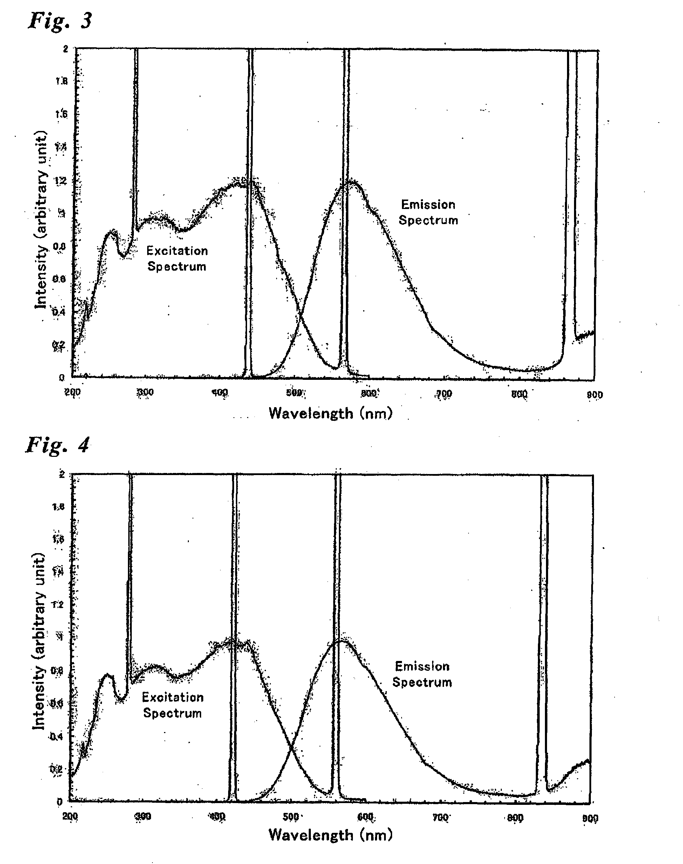

These powder samples were irradiated with light having a wavelength of 365 nm by the lamp such that the emission colors were confirmed. Emission spectra and excitation spectra of these powder samples were measured with a fluorescence spectrophotometer and obtained peak wavelengths of the excitation spectra, peak wavelengths of the emission spectra, and peak heights of the emission spectra are summarized in Table 5 and will be described later. The emission spectra and the excitation spectra of Examples 2, 11, 17, and 29 are shown in Figs. 3 to 6, respectively, and will be described later.

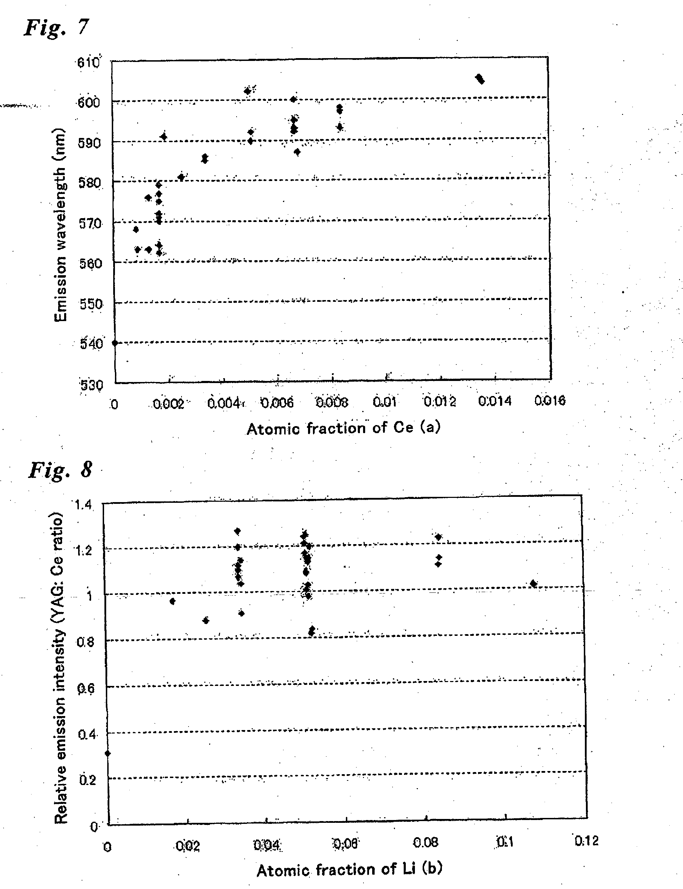

Utilizing the results as shown in Table 5, the relationship between the atomic fraction of Ce (a) and the peak wavelength; the relationship between the atomic fraction of Li (b) and the emission intensity; and the relationship between the atomic fraction of O (g) and the emission intensity were investigated, respectively. The results are shown in Figs. 7 to 9 and will be described later.

[Comparative example 1]

In order to investigate an effect of Li on the phosphor of the present invention, inorganic compounds including Ce, Ca, Al, Si, oxygen, and nitrogen, but excluding Li, were synthesized. The design parameters are shown in Tables 1 and 2 and, based on these design parameters, Si$_3$N$_4$, AlN, Al$_2$O$_3$, Ca$_3$N$_2$, and CeO$_2$ powder samples were mixed according to the compositions as shown in Table 3.

The processes for synthesizing the compounds were the same as those of Examples 1 to 31 except that the firing temperature was set to be 1900 °C. The compounds obtained after the firing process were examined by the powder X-ray diffraction measurement. The compounds were ground so as to be in a powder state in which the mean particle sizes thereof were 5 to 8 $\mu$m. These powdered samples were irradiated by the lamp emitting light of a wavelength of 365 nm and the emission colors were confirmed. The excitation spectra and emission spectra of these powdered samples were measured with the fluorescence spectrophotometer. The results are summarized in Table 5 and will be described later.

[Comparative example 2]

In order to investigate an effect of Ce on the phosphor of the present invention, inorganic compounds including Li, Ca, Al, Si, oxygen, and nitrogen, but excluding Ce, were synthesized. The design parameters are shown in Tables 1 and 2 and, based on these design parameters, $Si_3N_4$, AlN, $Al_2O_3$, $Ca_3N_2$, and $Li_3N$ powder samples were mixed according to the compositions as shown in Table 3.

The processes for synthesizing the compounds were the same as those of Examples 1 to 31 except that the firing temperature was set to be 1900 °C. The compounds obtained after the firing process were examined by the powder X-ray diffraction measurement. The compounds were ground so as to be in a powder state in which the mean particle sizes thereof were 5 to 8 $\mu$m. These powdered samples were irradiated by the lamp emitting light of a wavelength of 365 nm and the emission colors were confirmed. The excitation spectra and emission spectra of these powdered samples were measured with the fluorescence spectrophotometer. The results are summarized in Table 5 and will be described later.

[Table 1]

| | Atomic fractions of constituent elements of phosphors (a, b, c, d, e, f, g, h) | | | | | | | | | |
|---|---|---|---|---|---|---|---|---|---|---|
| | a | b | c | d | e | f | g | h | e/d | g/h |
| | Ce | Li | CaSr | Al | Si | X | O | N | Si/Al | O/N |
| Example 1 | 0.0017 | 0.0503 | 0.1091 | 0.1091 | 0.2265 | 0 | 0.0084 | 0.495 | 2.08 | 0.01697 |
| Example 2 | 0.0017 | 0.0516 | 0.0861 | 0.0861 | 0.2582 | 0 | 0.0344 | 0.4819 | 3 | 0.07 |
| Example 3 | 0.0017 | 0.0508 | 0.1015 | 0.1015 | 0.2369 | 0 | 0.0169 | 0.4907 | 2.33 | 0.03 |
| Example 4 | 0.0008 | 0.0508 | 0.1016 | 0.1016 | 0.2371 | 0 | 0.0169 | 0.4911 | 2.33 | 0.03 |
| Example 5 | 0.0017 | 0.0344 | 0.1033 | 0.1033 | 0.241 | 0 | 0.0344 | 0.4819 | 2.33 | 0.07 |
| Example 6 | 0.0017 | 0.0344 | 0.1033 | 0.1033 | 0.241 | 0 | 0.0344 | 0.4819 | 2.33 | 0.07 |
| Example 7 | 0.0017 | 0.0344 | 0.1033 | 0.1033 | 0.241 | 0 | 0.0344 | 0.4819 | 2.33 | 0.07 |
| Example 8 | 0.0017 | 0.0521 | 0.0781 | 0.0781 | 0.2691 | 0 | 0.0434 | 0.4774 | 3.45 | 0.09 |
| Example 9 | 0.0013 | 0.0508 | 0.1016 | 0.1016 | 0.237 | 0 | 0.0169 | 0.4909 | 2.33 | 0.03 |
| Example 10 | 0.0009 | 0.0512 | 0.0939 | 0.0939 | 0.2477 | 0 | 0.0256 | 0.4868 | 2.64 | 0.05 |
| Example 11 | 0.0013 | 0.0512 | 0.0939 | 0.0939 | 0.2476 | 0 | 0.0256 | 0.4866 | 2.64 | 0.05 |
| Example 12 | 0.0017 | 0.0512 | 0.0939 | 0.0939 | 0.2474 | 0 | 0.0256 | 0.4863 | 2.63 | 0.05 |
| Example 13 | 0.0017 | 0.0519 | 0.0821 | 0.0821 | 0.2636 | 0 | 0.0389 | 0.4797 | 3.21 | 0.08 |
| Example 14 | 0.0017 | 0.0338 | 0.1184 | 0.1184 | 0.22 | 0 | 0.0169 | 0.4907 | 1.86 | 0.03 |
| Example 15 | 0.0067 | 0.0505 | 0.101 | 0.101 | 0.2357 | 0 | 0.0168 | 0.4882 | 2.33 | 0.03 |
| Example 16 | 0.0068 | 0.0514 | 0.0856 | 0.0856 | 0.2568 | 0 | 0.0342 | 0.4795 | 3 | 0.07 |
| Example 17 | 0.0034 | 0.0507 | 0.1014 | 0.1014 | 0.2365 | 0 | 0.0169 | 0.4899 | 2.33 | 0.03 |
| Example 18 | 0.0025 | 0.0507 | 0.1014 | 0.1014 | 0.2367 | 0 | 0.0168 | 0.4903 | 2.33 | 0.03 |
| Example 19 | 0.0019 | 0.1075 | 0.0461 | 0.0461 | 0.2917 | 0 | 0.0154 | 0.4914 | 6.33 | 0.03 |
| Example 20 | 0.0051 | 0.0843 | 0.0675 | 0.0675 | 0.2698 | 0 | 0.0169 | 0.489 | 4 | 0.03 |
| Example 21 | 0.0084 | 0.084 | 0.0672 | 0.00672 | 0.2689 | 0 | 0.0168 | 0.4874 | 4 | 0.03 |
| Example 22 | 0.0051 | 0.0506 | 0.1012 | 0.1012 | 0.2361 | 0 | 0.0169 | 0.489 | 2.33 | 0.03 |
| Example 23 | 0.0067 | 0.0505 | 0.101 | 0.101 | 0.2357 | 0 | 0.0168 | 0.4882 | 2.33 | 0.03 |
| Example 24 | 0.0084 | 0.0504 | 0.1008 | 0.1008 | 0.2353 | 0 | 0.0168 | 0.4874 | 2.33 | 0.03 |
| Example 25 | 0.0034 | 0.0338 | 0.1182 | 0.1182 | 0.2196 | 0 | 0.0169 | 0.4899 | 1.86 | 0.03 |
| Example 28 | 0.0051 | 0.0337 | 0.118 | 0.118 | 0.2192 | 0 | 0.0169 | 0.489 | 1.86 | 0.03 |

(continued)

| | Atomic fractions of constituent elements of phosphors (a, b, c, d, e, f, g, h) | | | | | | | | | |
|---|---|---|---|---|---|---|---|---|---|---|
| | a | b | c | d | e | f | g | h | e/d | g/h |
| | Ce | Li | CaSr | Al | Si | X | O | N | Si/Al | O/N |
| Example 27 | 0.0067 | 0.0337 | 0.1178 | 0.1178 | 0.2189 | 0 | 0.0168 | 0.4882 | 1.86 | 0.03 |
| Example 28 | 0.0084 | 0.0336 | 0.1176 | 0.1176 | 0.2185 | 0 | 0.0168 | 0.4874 | 1.86 | 0.03 |
| Example 29 | 0.0067 | 0.0842 | 0.0673 | 0.0673 | 0.2694 | 0 | 0.0168 | 0.4882 | 4 | 0.03 |
| Example 30 | 0.0135 | 0.0253 | 0.118 | 0.118 | 0.2192 | 0 | 0.0253 | 0.4806 | 1.86 | 0.05 |
| Example 31 | 0.0136 | 0.017 | 0.119 | 0.119 | 0.2211 | 0 | 0.034 | 0.4762 | 1.86 | 0.07 |
| Comparative example 1 | 0.005 | 0 | 0.1658 | 0.1658 | 0.1658 | 0 | 0 | 0.4975 | 1 | 0 |
| Comparative example 2 | 0 | 0.05 | 0.1167 | 0.1167 | 0.2167 | 0 | 0 | 0.5 | 1.86 | 0 |

Table 1: Atomic fractions (parameters) of constituent elements of phosphors according to Examples 1-31 & Comparative examples 1-2

[Table 2]

| | Constituent parameters of compositions of host crystals of phosphors (x1, x2, x3, x4) | | | | |
|---|---|---|---|---|---|
| | Activating element | x1 | x2 | x3 | x4 |
| | Ce | $LiSi_2N_3$ | $CaAlSiN_3$ | $SrAlSiN_3$ | $Si_2N_2O$ |
| Example 1 | 0.01 | 0.3 | 0.65 | 0 | 0.05 |
| Example 2 | 0.01 | 0.3 | 0.5 | 0 | 0.2 |
| Example 3 | 0.01 | 0.3 | 0.6 | 0 | 0.1 |
| Example 4 | 0.005 | 0.3 | 0.6 | 0 | 0.1 |
| Example 5 | 0.01 | 0.2 | 0.6 | 0 | 0.2 |
| Example 6 | 0.01 | 0.2 | 0.54 | 0.06 | 0.2 |
| Example 7 | 0.01 | 0.2 | 0.48 | 0.12 | 0.2 |
| Example 8 | 0,01 | 0.3 | 0.45 | 0 | 0.25 |
| Example 9 | 0.0075 | 0.3 | 0.6 | 0 | 0.1 |
| Example 10 | 0.005 | 0.3 | 0.55 | 0 | 0.15 |
| Example 11 | 0.0075 | 0.3 | 0.55 | 0 | 0.15 |
| Example 12 | 0.01 | 0.3 | 0.55 | 0 | 0.15 |
| Example 13 | 0.01 | 0.3 | 0.45 | 0.025 | 0.225 |
| Example 14 | 0.01 | 0.2 | 0.7 | 0 | 0.1 |
| Example 15 | 0.04 | 0.3 | 0.6 | 0 | 0.1 |
| Example 16 | 0.04 | 0.3 | 0.5 | 0 | 0.2 |
| Example 17 | 0.02 | 0.3 | 0.6 | 0 | 0.1 |
| Example 18 | 0.015 | 0.3 | 0.6 | 0 | 0.1 |
| Example 19 | 0.0125 | 0.7 | 0.3 | 0 | 0.1 |
| Example 20 | 0.03 | 0.5 | 0.4 | 0 | 0.1 |

(continued)

|  | Constituent parameters of compositions of host crystals of phosphors (x1, x2, x3, x4) | | | | |
|---|---|---|---|---|---|
|  | Activating element | x1 | x2 | x3 | x4 |
|  | Ce | $LiSi_2N_3$ | $CaAlSiN_3$ | $SrAlSiN_3$ | $Si_2N_2O$ |
| Example 21 | 0.05 | 0.5 | 0.4 | 0 | 0.1 |
| Example 22 | 0.03 | 0.3 | 0.6 | 0 | 0.1 |
| Example 23 | 0.04 | 0.3 | 0.6 | 0 | 0.1 |
| Example 24 | 0.05 | 0.3 | 0.6 | 0 | 0.1 |
| Example 25 | 0.02 | 0.2 | 0.7 | 0 | 0.1 |
| Example 26 | 0.03 | 0.2 | 0.7 | 0 | 0.1 |
| Example 27 | 0.04 | 0.2 | 0.7 | 0 | 0.1 |
| Example 28 | 0.05 | 0.2 | 0.7 | 0 | 0.1 |
| Example 29 | 0.04 | 0.5 | 0.4 | 0 | 0.1 |
| Example 30 | 0.08 | 0.15 | 0.7 | 0 | 0.15 |
| Example 31 | 0.08 | 0.1 | 0.7 | 0 | 0.2 |
| Comparative example 1 | 0.03 | 0 | 0.2 | 0.8 | 0 |
| Comparative example 2 | 0 | 0.3 | 0.7 | 0 | 0 |
| Table 2: Constituent parameters of compositions of host crystals of phosphors according to Examples 1-31 & Comparative examples 1-2 | | | | | |

[Table 3]

|  | Mixture compositions of raw materials (mass %) | | | | | | |
|---|---|---|---|---|---|---|---|
|  | $Si_3N_4$ | AlN | $Al_2O_3$ | $Li_3N$ | $Ca_3N_2$ | $Sr_3N_2$ | $CeO_2$ |
| Example 1 | 49.58 | 20.17 | 0.93 | 2.74 | 25.23 | 0.00 | 1.35 |
| Example 2 | 57.59 | 12.68 | 5.10 | 2.86 | 20.29 | 0.00 | 1.41 |
| Example 3 | 52.17 | 17.75 | 2.30 | 2.78 | 23.63 | 0.00 | 1.37 |
| Example 4 | 52.51 | 17.70 | 2.52 | 2.79 | 23.79 | 0.00 | 0.69 |
| Example 5 | 52.38 | 15.63 | 5.03 | 1.88 | 23.73 | 0.00 | 1.38 |
| Example 6 | 51.21 | 15.28 | 4.92 | 1.82 | 20.88 | 4.55 | 1.35 |
| Example 7 | 50.09 | 14.95 | 4.81 | 1.78 | 18.15 | 8.90 | 1.32 |
| Example 8 | 60.43 | 10.03 | 6.66 | 2.90 | 18.54 | 0.00 | 1.44 |
| Example 9 | 52.32 | 17.55 | 2.61 | 2.78 | 23.70 | 0.00 | 1.03 |
| Example 10 | 55.19 | 15.07 | 4.08 | 2.84 | 22.13 | 0.00 | 0.70 |
| Example 11 | 55.00 | 15.05 | 4.03 | 2.83 | 22.05 | 0.00 | 1.05 |
| Example 12 | 54.81 | 15.02 | 3.98 | 2.82 | 21.97 | 0.00 | 1.39 |
| Example 13 | 58.43 | 11.25 | 5.85 | 2.85 | 18.22 | 1.99 | 1.41 |
| Example 14 | 47.24 | 20.49 | 2.24 | 1.80 | 26.88 | 0.00 | 1.34 |
| Example 15 | 50.22 | 18.03 | 1.04 | 2.67 | 22.75 | 0.00 | 5.28 |
| Example 16 | 55.38 | 13.16 | 3.76 | 2.75 | 19.51 | 0.00 | 5.44 |
| Example 17 | 51.50 | 17.85 | 1.87 | 2.74 | 23.33 | 0.00 | 2.71 |

(continued)

| | Mixture compositions of raw materials (mass %) | | | | | | |
|---|---|---|---|---|---|---|---|
| | $Si_3N_4$ | AlN | $Al_2O_3$ | $Li_3N$ | $Ca_3N_2$ | $Sr_3N_2$ | $CeO_2$ |
| Example 18 | 51.79 | 17.46 | 2.49 | 2.76 | 23.46 | 0.00 | 2.04 |
| Example 19 | 68.00 | 10.52 | 0.00 | 6.95 | 12.88 | 0.00 | 1.84 |
| Example 20 | 61.17 | 12.18 | 1.53 | 4.75 | 16.16 | 0.00 | 4.22 |
| Example 21 | 59.59 | 12.52 | 0.68 | 4.62 | 15.74 | 0.00 | 6.86 |
| Example 22 | 50.86 | 17.94 | 1.45 | 2.71 | 23.04 | 0.00 | 4.01 |
| Example 23 | 50.22 | 18.03 | 1.04 | 2.67 | 22.75 | 0.00 | 5.28 |
| Example 24 | 49.61 | 18.12 | 0.64 | 2.64 | 22.47 | 0.00 | 8.52 |
| Example 25 | 46.65 | 20.55 | 1.83 | 1.78 | 26.55 | 0.00 | 2.64 |
| Example 26 | 46.08 | 20.61 | 1.42 | 1.76 | 26.22 | 0.00 | 3.91 |
| Example 27 | 45.52 | 20.67 | 1.02 | 1.74 | 25.90 | 0.00 | 5.16 |
| Example 28 | 44.97 | 20.72 | 0.63 | 1.72 | 25.59 | 0.00 | 6.37 |
| Example 29 | 60.37 | 12.35 | 1.10 | 4.68 | 15.95 | 0.00 | 5.56 |
| Example 30 | 43.49 | 19.94 | 0.73 | 1.25 | 24.75 | 0.00 | 9.85 |
| Example 31 | 43.56 | 19.00 | 1.95 | 0.83 | 24.79 | 0.00 | 9.87 |
| Comparative example 1 | 25.92 | 22.73 | 0.00 | 0.00 | 5.48 | 43.01 | 2.86 |
| Comparative example 2 | 47.65 | 22.50 | 0.00 | 2.73 | 27.12 | 0.00 | 0.00 |
| Table 3: Mixture compositions of raw materials of Examples 1-31, & Comparative examples 1-2 | | | | | | | |

Fig. 1 is a diagram showing an X-ray diffraction result of the phosphor of Example 2.

Fig. 2 is a diagram showing an X-ray diffraction result of the phosphor of Example 29.

It was confirmed that both phosphors of Examples 2 and 29 had solid solution of the $CaAlSiN_3$ crystal as the main crystal according to Figs. 1 and 2. It was also confirmed that the other examples and comparative examples showed similar diffraction patterns such that more than 80% of $CaAlSiN_3$, $SrAlSiN_3$, or $LiSi_2N_2$, or solid solution crystals thereof was contained.

[Table 4]

| Element | Example 3 | | | Example 27 | | |
|---|---|---|---|---|---|---|
| Sample number | 540902 | | | 541002 | | |
| | Designed value (wt%) | Measured value (wt%) | Relative comparison (Designed value/ Measured value) | Designed value (wt%) | Measured value (wt%) | Relative comparison (Designed value/ Measured value) |
| Ce | 1.12 | 1.13±0.01 | 0.99 | 4.2 | 4.20±0.01 | 1.00 |
| Ca | 19.2 | 19.6±0.1 | 0.97 | 21.15 | 27.3±0.1 | 0.99 |
| Al | 12.92 | 12.8±0.1 | 1.00 | 14.24 | 14.1±0.1 | 1.01 |
| Si | 31.39 | 31.7±0.1 | 0.99 | 27.53 | 27.6±0.1 | 0.99 |
| N | 32.43 | 30.0±0.1 | 1.08 | 30.63 | 28.9±0.1 | 1.06 |
| Table 4: Results of wet chemical analyses of phosphors of Examples 3 and 27 | | | | | | |

Table 4 shows results of the wet chemical anlayses of the phosphors of Examples 3 and 27. In Table 4, concentrations (wt%) calculated from the design compositions (Table 1) of the phosphors of Examples 3 and 27 are shown as the design values, and relative ratios of the design values and the measurement values are also shown. With reference to the retative ratios as shown in Table 4, the ratio for any one of the elements was found to be substantially equalt to one (1). This means that the design compositions and the actual compositions of the phosphors haveing been actually manufactured are the same with respect to the phosphors manufactured by the manufacturing method of the present invention. The same results were also obtained with respect to the other Examples. As mentioned above, the desing compositions and the actual compositions of the phosphors having been manufactured are identical such that the design compositions as shown in Table 1 are also handled as the compositions of the phosphors having been manufactured in the present specification.

Next, detailed explanation will be made with respect to the emission colors uppon irradiation by the lamp emitting light of a wavelength of 365 nm. It was confirmed that any of phosphors of Examples 1 to 14 made a yellow color emission. It was confirmed that any of phosphors of Examples 15 to 28 made an orange color emission. It was confirmed that any of phosphors of Examples 29 to 31 made a red color emission. It was confirmed that the phosphors of Comparative examples 1 and 2 slightly made a red color emission and a green color emission, respectively. The intensities of the emissions were quite low.

Peak wavelengths of excitation spectra, peak wavelengths of emission spectra, and heights of the emmision spectra measured with the fluorescence spectrophotometer are summarized in Table 5. Here, since the counted values vary depending on the measuring instruments and conditions, the unit of the values is an arbitrary unit. That is, comparisons thereof can be made only within the present examples and comparative example measured in the same conditions. Values of the emission intensities of the phosphors of the present invention divided by the peak heights of YAG: Ce phosphor upon excitation by light of 450 nm are also shown in Table 5 for the reference.

[Table 5]

|  | Excitation wavelength (nm) | Emission wavelength (nm) | Emission Intensity (arbitrary unit) |
|---|---|---|---|
| Example 1 | 440 | 579 | 1.24 |
| Example 2 | 440 | 570 | 1.2 |
| Example 3 | 439 | 576 | 1.09 |
| Example 4 | 421 | 568 | 1.01 |
| Example 5 | 440 | 572 | 1.14 |
| Example 6 | 421 | 571 | 1.04 |
| Example 7 | 440 | 584 | 0.91 |
| Example 8 | 438 | 564 | 0.84 |
| Example 9 | 439 | 576 | 1.08 |
| Example 10 | 439 | 563 | 1.03 |
| Example 11 | 421 | 563 | 0.98 |
| Example 12 | 439 | 575 | 1.13 |
| Example 13 | 439 | 562 | 0.82 |
| Example 14 | 441 | 577 | 1.12 |
| Example 15 | 442 | 592 | 1.17 |
| Example 16 | 443 | 587 | 1.15 |
| Example 17 | 441 | 586 | 1.25 |
| Example 18 | 441 | 581 | 1.09 |
| Example 19 | 440 | 591 | 1.02 |
| Example 20 | 439 | 592 | 1.14 |
| Example 21 | 442 | 593 | 1.11 |
| Example 22 | 441 | 592 | 1.21 |
| Example 23 | 441 | 593 | 1.17 |

(continued)

|  | Excitation wavelength (nm) | Emission wavelength (nm) | Emission Intensity (arbitrary unit) |
|---|---|---|---|
| Example 24 | 442 | 597 | 1.21 |
| Example 25 | 440 | 585 | 1.27 |
| Example 26 | 442 | 590 | 1.2 |
| Example 27 | 447 | 590 | 0.97 |
| Example 28 | 448 | 598 | 1.07 |
| Example 29 | 442 | 600 | 1.23 |
| Example 30 | 448 | 605 | 0.88 |
| Example 31 | 448 | 604 | 0.97 |
| Comparative example 1 | 447 | 602 | 0.31 |
| Comparative example 2 | 414 | 540 | 0.15 |
| Table 5: Peak values in excitation wavelength & emission wavelength, & relative emission intensity according to Examples 1-31 & Comparative examples 1-2 | | | |

[Table 6]

| Crystal construction data of CaAlSiN3 CaAlSiN3 Space Group (#36) Cmc21 | | | | |
|---|---|---|---|---|
| Lattice constant (A) | a | b | c | |
| | 9.8007(4) | 5.6497(2) | 5.0627(2) | |
| | | | | |
| | Site | x | y | z |
| Si/Al | 8(b) | 0.1734(2) | 0.1565(3) | 0.0505(4) |
| N1 | 8(b) | 0.2108(4) | 0.1205(8) | 0.3975(2) |
| N2 | 4(a) | 0 | 0.2453(7) | 0.0000(10) |
| Ca | 4(a) | 0 | 0.3144(3) | 0.5283 |
| | | | | |
| SiN2O Space Group (#36) Cmc21 | | | | |
| Lattice constant (Å) | a | b | c | |
| | 8.8717 | 5.4909 | 4.8504 | |
| | | | | |
| | Site | x | y | z |
| Si | 8(b) | 0.1767 | 0.1511 | 0.0515 |
| N | 8(b) | 0.21191 | 0.1228 | 0.3967 |
| O | 4(a) | 0 | 0.2127 | 0 |

In all Examples 1 to 31, phosphors which were efficiently excited by an ultraviolet ray, violet light, or blue light of a wavelength in the range from 250 nm to 480 nm and emitted fluorescence having a peak at a wavelength in the wavelength range of at least 560 nm and not exceeding 620 nm were obtained according to Table 5. More specifically, the phosphors of Examples 1 to 14 emitted fluorescence having a peak at a wavelength in the range of at least 560 nm and less than 580 nm, the phosphors of Examples 15 to 28 emitted fluorescence having a peak at a wavelength in the range of at least 580 nm and less than 600 nm, and the phosphors of Examples 29 to 31 emitted fluorescence having a peak at a wavelength in the range of at least 600 nm and not exceeding 620 nm. On the other hand, the phosphors of Comparative examples 1 and 2 emitted fluorescence having peaks at the wavelength of 602 nm and at the wavelength of 540 nm, respectively.

With respect to the emission intensities, the phosphors of Examples 1 to 31 exhibited about one (1) of the emission intensity comparable to the YAG: Ce phosphors such that it was confirmed that the phosphors exhibited sufficiently high emission intensities for the practical use. On the other hand, the emission intensities of the phosphors of Comaprative examples 1 and 2 are 0.31 and 0.15, respectively such that it was found that the emission intensities were low.

Fig. 3 is a diagram showing excitation and emission spectra by the phosphor of Example 2.

Fig. 4 is a diagram showing excitation and emission spectra by the phosphor of Example 11.

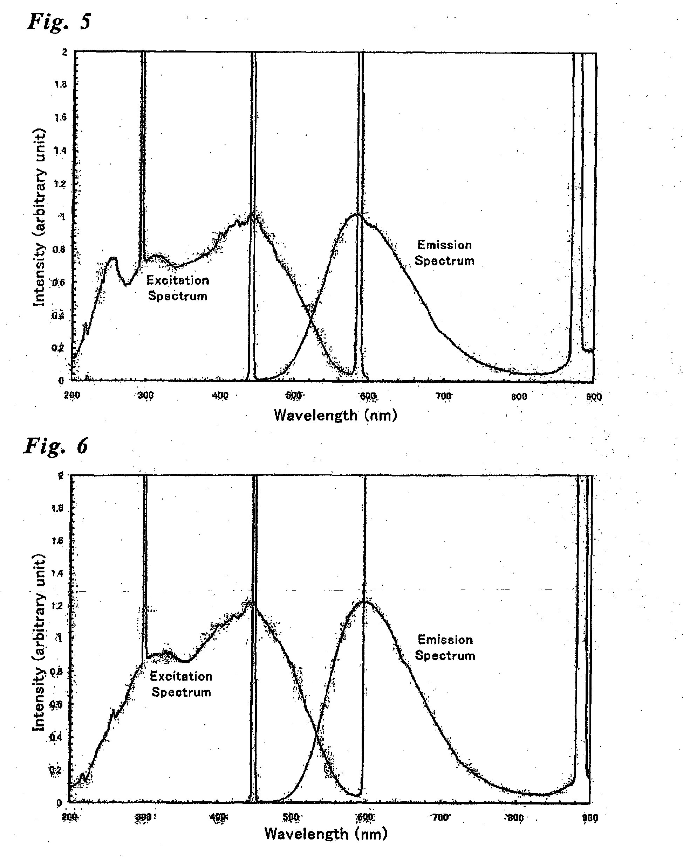

Fig. 5 is a diagram showing excitation and emission spectra by the phosphor of Example 17.

Fig. 6 is a diagram showing excitation and emission spectra by the phosphor of Example 29.

As shown in Figs. 3 to 6, phosphors of the present inventions are **characterized in that** they can be excited by excitation light of a broad band from 250 to 480 nm and that the excitation intensity is, in particular, high by a violet LED of 405 nm wavelength and a blue LED of 450 nm wavelength. Here, peaks having the emission intensity exceeding the upper limit (value of 2) of the graph may be assigned to direct light from the excitation light or light at a double wavelength and they are not assigned to the actual emission such that they may be ignored, and other lines than them have the real meaning.

As shown in Figs. 3 and 4, the emission color of the phosphors of Examples 2 and 11 was yellow; as shown in Fig. 5, the emission color of the phosphor of Example 17 was orange; as shown in Fig. 6, and the emission color of the phosphor of Example 29 was red. In this way, even though the phosphor of the present invention has the same constituent elements and the same host crystal, the phosphor was found to exhibit a desired emission color in the range of at least 560 nm and not exceeding 620 nm by controlling a composition thereof.

Next, the relationship between the atomic fractions of Ce, Li, and O (a, b, and g) and the emission wavelength or the emission intensity was investigated based on Table 4.

Fig. 7 is a diagram showing the relationship between the atomic fraction of Ce (a) and the emission wavelength.

Fig. 8 is a diagram showing the relationship between the atomic fraction of Li (b) and the emission intensity.

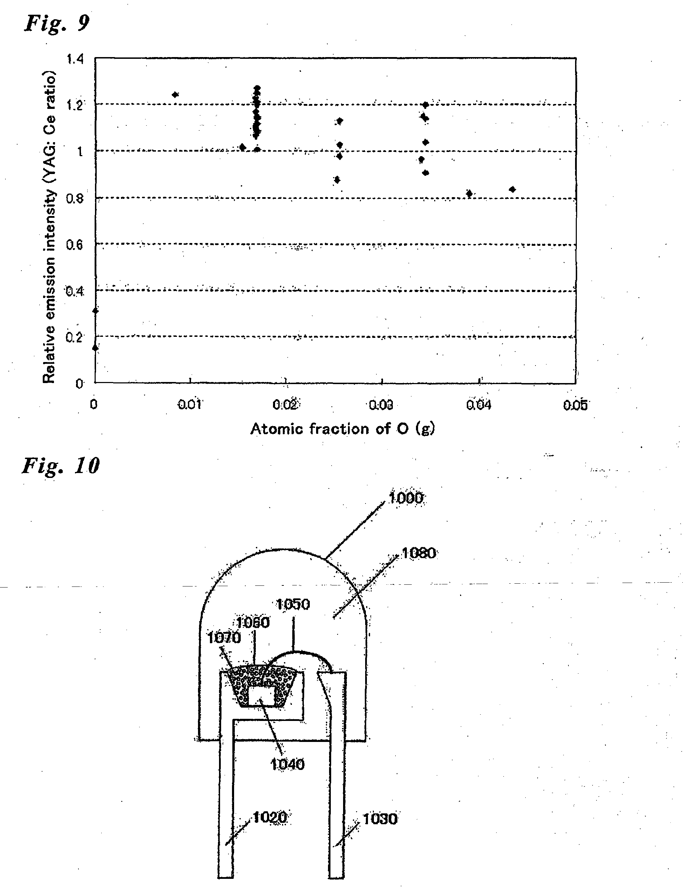

Fig. 9 is a diagram showing the relationship between the atomic fraction of O (g) and the emission intensity.

According to Fig. 7, as the atomic fraction of Ce (a) is increased, that is, as the concentration of Ce is increased, the emission wavelength of the phosphor tends to be longer. It may be good to select a composition area where the atomic fraction of Ce (a) is rather small for the application of a short emission wavelength and to select a composition area where the atomic fraction of Ce (a) is rather large for the application of a long emission wavelength althugh it is necessary to desing the composition for each case individually since the emission intensity of each phosphor is affected by the other atomic fractions of the other elements than the atomic fraction of Ce (a).

According to Fig. 8, where the atomic fraction of Li (b) is not added, the emission intensity is low. In order to obtain a high emission intensity, the atomic fraction of Li (b) is preferably in the range from 0.005 to 0.11, and more preferably from 0.015 to 0.11.

According to Fig. 9, where the atomic fraction of O (g) is not added, the emission intensity is low. In order to obtain a high emission intensity, the atomic fraction of O (g) is preferably in the range from 0.008 to 0.1, and more preferably from 0.008 to 0.045.

As mentioned above, it was found that the phosphor was obtained wherein the phosphor included at least at least Li, Ca, Si, Al, O, N, and Ce elements; and had as the host crystal the $CaAlSiN_3$ crystal or a crystal having the same crystal structure as the $CaAlSiN_3$ crystal. Further, it was also found that the atomic fraction of Ce might be preferably controlled in order to control the emission wavelength of the phosphor and that the atomic fraction of Li or O might be preferably controlled in order to control the emission intensity of the phosphor. It was found that the phosphor having a desired emission color (yellow, orange, or red color) and retaining a high emission intensity could be obtained by controlling each atomic fraction of each constituent element.

Therefore, it has now become possible to provide the following phosphors.

(1) A phosphor comprising as a host crystal a $CaAlSiN_3$ crystal or a crystal having a same crystal structure as the $CaAlSiN_3$ crystal and **t h e phosphor** including at least Li, Ca, Si, Al, O (oxygen), N (nitrogen), and Ce elements, **wherein an atomic fraction of a of Ce and an atomic fraction of b of Li satisfy:**

$$b \geq 1.2 \times a .$$

(2) The phosphor according to the above (1), further comprising Sr element.

(3) The phosphor according to the above (1), wherein an atomic fraction of d of Al and an atomic fraction of e of Si satisfy:

$$1.5 \leq e/d \leq 9 .$$

(4) The phosphor according to the above (1), wherein an atomic fraction of g of O and an atomic fraction of h of N satisfy:

$$0.015 \leq g/h \leq 0.1 .$$

(5) The phosphor according to the above (1), wherein
the phosphor emits fluorescence having a peak at a wavelength in a range of at least 560 nm and not exceeding 620 nm upon irradiation of an excitation source.

(**6**) The phosphor according to the above (**5**), wherein the atomic fraction of a of Ce satisfies a condition:

$$0.0007 \leq a \leq 0.01 ,$$

and
the phosphor emits fluorescence having a peak at a wavelength in a range of at least 560 nm and less than 580 nm upon irradiation of an excitation source.

(**7**) The phosphor according to the above (**5**), wherein the atomic fraction of a of Ce satisfies a condition:

$$0.0019 \leq a \leq 0.0085 ,$$

and
the phosphor emits fluorescence having a peak at a wavelength in a range of at least 580 nm and less than 600 nm upon irradiation of an excitation source.

(**8**) The phosphor according to the above (**7**), wherein the atomic fraction of b of Li; the atomic fraction of c of Ca; the atomic fraction of d of Al; the atomic fraction of e of Si; the atomic fraction of g of O; and the atomic fraction of h of N satisfy following conditions:

$$0.03 \leq b \leq 0.11 ,$$

$$0.04 \leq c \leq 0.12 ,$$

$$0.04 \leq d \leq 0.12 ,$$

$$0.21 \leq e \leq 0.3 ,$$

$$0.015 \leq g \leq 0.05 ,$$

and

$$0.45 \leq h \leq 0.5 \ .$$

(**9**) The phosphor according to the above (**5**), wherein the atomic fraction of a of Ce satisfies a condition:

$$0.006 \leq a \leq 0.018 \ ,$$

and
the phosphor emits fluorescence having a peak at a wavelength in a range of at least 600 nm and not exceeding 620 nm upon irradiation of an excitation source.
(**10**) The phosphor according to the above (**9**), wherein the atomic fraction of b of Li; the atomic fraction of c of Ca; the atomic fraction of d of Al; and the atomic fraction of g of O satisfy following conditions:

$$0.016 \leq b \leq 0.04 \ ,$$

$$0.06 \leq c \leq 0.13 \ ,$$

$$0.06 \leq d \leq 0.13 \ ,$$

and

$$0.015 \leq g \leq 0.05 \ .$$

(**11**) The phosphor according to the above (1), wherein the host crystal is an inorganic crystal having a composition of $x_1 LiSi_2N_3 + x_2 CaAlSiN_3 + x_3 SrAlSiN_3 + x_4 Si_2N_2O$ ($x_1$, $x_2$, $x_3$, and $x_4$ are numerical values of at least zero (0) and not exceeding one (1) to indicate fractions; and $x_1 + x_2 + x_3 + x_4 = 1$ in the formula), and the parameters: $x_1$, $x_2$, $x_3$, and $x_4$ satisfy following conditions:

$$0.02 \leq x_1 \leq 0.80 \ ,$$

$$0.20 \leq x_2 + x_3 \leq 0.80 \ ,$$

and

$$0.04 \leq x_4 \leq 0.30 \ ,$$

and
Ce is incorporated into the inorganic crystal in solid solution,
(**12**) The phosphor according to the above (1), wherein the host crystal is **selected from a group consisting of** $CaAlSiN_3$, $LiSi_2N_3$, and $Si_2N_2O$, a solid solution crystal thereof, **and a crystal having an identical crystal structure to any once** of **thus-mentioned crystals.**
(**13**) A method of manufacturing the phosphor recited in the above (1), comprising: a step of firing a raw material mixture of metal compound inlcuding at least Ce, Li, Ca, Si, Al, and N, and, as necessary, Sr and/or O, in a nitrogen atmosphere in a temperature range of at least $15 \times 10^2$ °C and not exceeding $22 \times 10^2$ °C.

Next, a light-emitting device utilizing the phosphor of the present invention will be described.

[Example 32]

Fig. 10 is a schematic diagram showing the light-emitting device (bullet-type white light-emitting diode lamp) according to the present invention.

A so-called bullet-type white light-emitting diode lamp 1000 as shown in Fig. 10 was produced. A lead wire 1030 of two lead wires 1020 and 1030 has a recess and a blue light-emitting diode element 1040 is placed in the recess. The lower electrode of the blue light-emitting diode element 1040 and the bottom surface of the recess are electrically connected with conductive paste, and the upper electrode and the lead wire 1030 are electrically connected by a gold filament 1050. The phosphor of a yellow color emission produced for Example 2 was adopted for the phosphor 1070. The phosphor 1070 was dispersed in a first resin 1060 and mounted in the vicinity of the blue light-emitting diode element 1040. The first resin 1060 In which this phosphor 1070 was dispersed was transparent, and covered the entire blue light-emitting diode element 1040. A tip portion of the lead wire 1020 having the recess, the blue light-emitting diode element 1040, and the first resin 1060 in which the phosphor 1070 was dispersed were sealed with transparent second resin 1080. The transparent second resin 1080 is, as a whole, shaped in an approximately circular cylindrical shape and an apical end part is formed in a curved face of a lens shape such that it is commonly called bullet-type in a vernacular term.

In the present example, the phosphor powder was mixed into epoxy resin in a concentration of 35 wt%, and a proper amount of the resultant mixture was dropped using a dispenser to form the first resin 1060 in which the phosphor 1070 was dispersed. The resultant color coordinates were x=0.33 and y=0.33, which represent a white color.

Next, the manufacturing process of the bullet-type white light-emitting diode of this example will be described. First, the blue light-emitting diode element 1040 was bonded on the recess (die bonding) with conductive paste, wherein the recess is formed on the other lead wire 1020 of a couple of lead wires for the purpose that a certain element may be placed thereon. The lead wire 1020 and the lower electrode of the blue light emitting diode element 1040 are electrically connected and the blue light emitting diode element 1040 is fixed thereon. Then, the upper electrode of the blue light-emitting diode element 1040 and the lead wire 1030 are wire-bonded with a gold filament 1050 and are electrically connected. The phosphor powder 1070 was mixed into epoxy resin in a concentration of 35 wt%. Then, a proper amount of this is applied utilizing a dispenser to the recess to cover the blue light-emitting diode element 1040 and it is cured to form the first resin 1060. Finally, the whole body including the apical end part of the lead wire 1020 including the recess, the blue light-emitting diode element 1040, and the first resin 1060 in which the phosphor 1070 is dispersed is sealed with the second resin 1080 by the casting method. In the present example, the same epoxy resin was used for both of the first resin 1060 and second resin 1080. However, transparent materials, such as other resin exemplified by silicone resin, or glass may also be applied. It is preferable to select a material which exhibits as small deterioration as possible by ultraviolet light.

[Example 33]

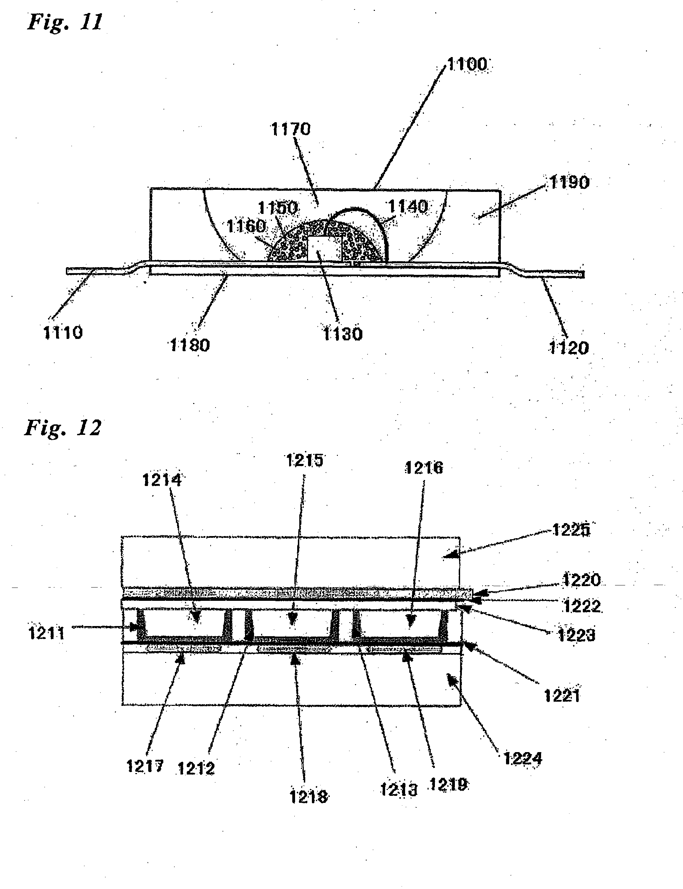

Fig. 11 is a schematic diagram showing a light emitting device (tip-type white light-emitting diode lamp for board mounting) according to the present invention.

A tip-type white light-emitting diode lamp for board mounting 1100 was manufactured. Two lead wires 1110 and 1120 are fixed to a white alumina ceramic board 1180 having high visible light reflectivity. One end of each of these wires is located nearly at the central part of the board, and the other end of each extends to the outside to serve as an electrode to be soldered when the lamp is mounted on an electric board. A blue light-emitting diode element 1130 is placed on and fixed to one end of the lead wire 1110 so that the diode is located at the central part of the board. The lower electrode of the blue light-emitting diode element 1130 and the lead wire 1110 are electrically connected with conductive paste, and the upper electrode and the lead wire 1120 are electrically connected with a gold filament 1140.

The phosphor 1160 is dispersed in the first resin 1150 and mounted in the vicinity of the blue light-emitting diode element 1130. As the phosphor therein, the phosphor emitting a yellow color emission produced for Example 2 was adopted. The first resin 1150 in which this phosphor 1160 is dispersed is transparent, and covered the entire blue light-emitting diode element 1130. Moreover, on the alumina ceramic board 1180, a wall surface member 1190 having a hole opened at the central part is fixed. The blue light-emitting diode element 1130 and the first resin 1150 in which the phosphor 1160 is dispersed are put into a hole at a central part of the wall surface member 1190. The central part has an inclined face and the inclined face is a reflective surface in order to forward light toward the front. The shape of the curved face of the inclined face is determined in consideration of the reflective direction. Moreover, at least the surface which constitutes the reflective surface forms a surface having high visible light reflectivity with white or metallic luster. In the present example, the wall surface member 1190 is constituted of white silicone resin. The hole at the central part of the wall surface member 1190 forms a recess as the final shape of the tip-type light emitting diode lamp, and is filled up with second transparent resin 1170 to seal all of the blue light-emitting diode device 1130 and the first resin 1150 in which the phosphor 1160 is dispersed. In the present example, the same epoxy resin was used for both the first resin 1150 and the second resin 1170. The percentage of phosphor addition, the attained chromaticity, and the like are approximately identical to those in Example 32. The manufacturing process is approximately identical to the production process of Example 32 except that the lead wires 1110 and 1120 and the wall surface member 1190 are fixed to the alumina ceramic board 1180.

Next, an example of design of an image display device using the phosphor of the present invention will be described.

[Example 34]

Fig. 12 is a schematic diagram showing an image display device (plasma display panel) according to the present invention.

A green color phosphor ($\beta$-sialon: Eu) 1211, a red color phosphor 1212 of Example 29 of the present invention, and a blue color phosphor ($BaMgAl_{10}O_{17}$: Eu) 1213 are applied on the interior surface of respective cells 1214, 1215, and 1216 disposed on a glass board 1224 to which a dielectric layer 1221 is applied. When an electric current is supplied to electrodes 1217, 1218, 1219, and 1220, a vacuum ultraviolet radiation ray is generated by Xe discharge in the cells, and each phosphor is excited by this radiation to emit visible light of red, green, and blue colors. The emitted light is observed from the outside via a protection layer 1223, a dielectric layer 1222, and a glass board 1225, and the device functions as an image display.

[Example 35]

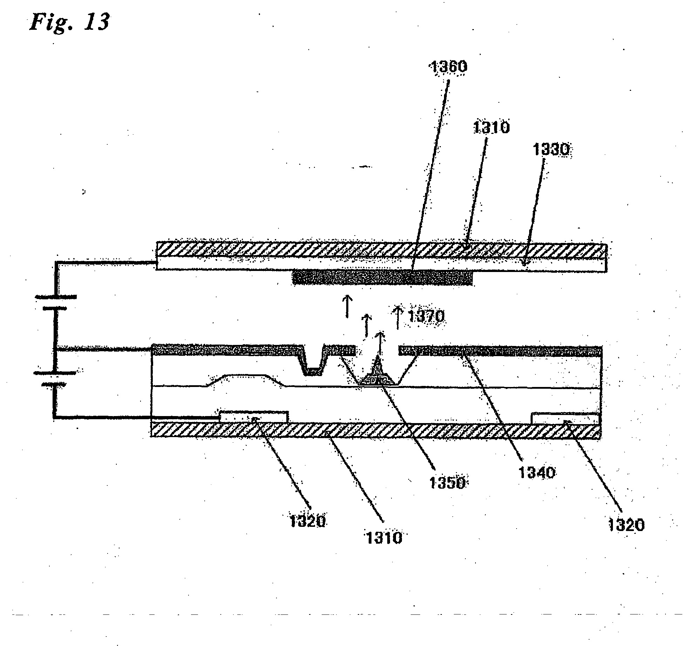

Fig. 13 is a schematic diagram showing an image display device (field emission display panel) according to the present invention.

The red phosphor 1360 of Example 29 of the present invention is applied to an interior surface of an anode 1330. By applying a voltage between a cathode 1320 and a gate 1340, electrons 1370 are emitted from an emitter 1350. The electrons 1370 are accelerated by the voltage between the anode 1330 and cathode 1320, and impinge on the phosphor 1360 to excite the phosphor to emit fluorescence. The entire device is protected by a glass plate 1310. The drawing shows a single light emission cell comprising one emitter and one phosphor. However, an actual display emitting a variety of colors is configured by arranging a large number of blue and green cells besides red cells. Although the phosphors used for blue and red cells are not particularly specified, a phosphor which shows high brightness under a low speed electron beam is preferable.

As described above, the following light-emitting device and image display device have become available.

(**14**) A light-emitting device comprising: at least an emission source and a phosphor, wherein the phosphor comprises the first phosphor recited in the above (1).

(**15**) The light-emitting device according to the above (**14**) wherein the emission source is an inorganic EL device, an organic EL device, a laser diode (LD), or a light-emitting diode (LED) emitting light of a wavelength from 330 to 500 nm.

(**16**) The light-emitting device according to the above (**14**) wherein the emission source is a LED or LD emitting light of a wavelength of at least 330 nm and less than 430 nm; the phosphor comprises a second phosphor emitting blue light having an emission peak at a wavelength of at least 430 nm and not exceeding 480 nm by light of a wavelength of at least 330 nm and less than 430 nm; white color light is emitted by mixing an emission color of the first phosphor and an emission color of the second phosphor.

(**17**) The light-emitting device according to the above (**16**) wherein the phosphor comprises a third phosphor emitting red light having an emission peak at a wavelength of at least 600 nm and not exceeding 700 nm by light of a wavelength of at least 330 nm and less than 430 nm; white color light is emitted by mixing the emission color of the first phosphor, the emission color of the second phosphor, and an emission color of the third phosphor.

(**18**) The light-emitting device according to the above (**14**), wherein the emission source is an LED or an LD emitting light of a wavelength of at least 430 nm and not exceeding 480; white color ligh is emitted by mixing an emission color of the emission source and an emission color of the first phosphor.

(**19**) The light-emitting device according to the above (**18**), wherein the phosphor comprises a fourth phosphor emitting green light having an emission peak at a wavelength of at least 520 nm and not exceeding 560 nm by light of a wavelength of at least 430 nm and not exceeding 480 nm; and/or a fifth phosphor emitting red light having an emission peak at a wavelength of at least 600 nm and not exceeding 700 nm by light of a wavelength of at least 430 nm and not exceeding 480 nm, and white color ligh is emitted by mixing the emission color of the emission source, the emission color of the first phosphor, an emission color of the fourth phosphor and/or an emission color of the fifth phosphor.

(**20**) The light-emitting device according to the above (**14**), wherein the phosphor comprises at least one phosphor selected from a group consisting of $\beta$-sialon phosphor activated with Eu; $\alpha$-sialon yellow phosphor activated with

Eu; $Sr_2Si_5N_6$ orange phosphor activated with Eu; (Ca, Sr)AlSiN$_3$ orange phosphor activated with Eu; CaAlSiN$_3$ red phosphor activated with Eu.

(**21**) An image diaplay device comprising: an excitation source by an electron beam, an electric field, a vacuum ultraviolet radiation ray, or ultra violet ray; and a phosphor wherein the phosphor comprises a phosphor recited in the above (1).

(**22**) The image display device according to the above (**21**) further comprising: a fluorescent display tube (VFD), a field emission display (FED), a plasma display panel (PDP), or a cathode-ray tube (CRT).

Industrial Applicability

The phosphor of the present invention emits fluorescence having a peak in a wavelength of a range of at least 560 nm and not exceeding 620 nm by controlling a composition thereof. In particular, a phosphor having a specific composition is excellent as a yellow, orange, or red phosphor, and deterioration of the brightness of the phosphor exposed to the excitation source is small such that it is a nitride phosphor to be used suitably in a VFD, an FED, a PDP, a CRT, a white LED, and so on. It is expected that the phosphor of the present Invention will be utilized in material design in various display devices so as to contribute to the development of the industry.

Explanation of Numerals

1000 bullet-type white emission diode lamp
1020, 1030, 1110, 1120 lead wire
1040, 1130 blue emission diode element
1050, 1140 gold filament
1070, 1160 phosphor
1060, 1150 first resin
1080, 1170 second resin
1100 tip-type white light-emitting diode lamp for mounted on board
1180 alumina ceramic board
1190 wall surface member
1211 green phosphor($\beta$-sialon: Eu)
1212 red phosphor
1213 blue phosphor (BaMgAl$_{10}$O$_{17}$: Eu)
1214, 1215, 1216 cell
1217, 1218, 1219, 1220 electrode
1223 protection layer
1221, 1222 dielectric layer
1224, 1225 glass substrate
1360 red phosphor
1330 anode

## Claims

1. A phosphor comprising as a host crystal a CaAlSiN$_3$ crystal or a crystal having a same crystal structure as the CaAlSiN$_3$ crystal and the phosphor including at least Li, Ca, Si, Al, O (oxygen), N (nitrogen), and Ce elements, wherein an atomic fraction of a of Ce and an atomic fraction of b of Li satisfy:

$$b \geq 1.2 \times a.$$

2. The phosphor according to claim 1, further comprising Sr element.

3. The phosphor according to claim 1, wherein an atomic fraction of d of Al and an atomic fraction of e of Si satisfy:

$$1.5 \leq e/d \leq 9 \ .$$

4. The phosphor according to claim 1, wherein an atomic fraction of g of O and an atomic fraction of h of N satisfy:

$$0.015 \leq g/h \leq 0.1 \ .$$

5. The phosphor according to claim 1, wherein the phosphor emits fluorescence having a peak at a wavelength in a range of at least 560 nm and not exceeding 620 nm upon irradiation of an excitation source.

6. The phosphor according to claim 5, wherein the atomic fraction of a of Ce satisfies a condition:

$$0.0007 \leq a \leq 0.01 \ ,$$

and
the phosphor emits fluorescence having a peak at a wavelength in a range of at least 560 nm and less than 580 nm upon irradiation of an excitation source.

7. The phosphor according to claim 5, wherein the atomic fraction of a of Ce satisfies a condition:

$$0.0019 \leq a \leq 0.0085 \ ,$$

and
the phosphor emits fluorescence having a peak at a wavelength in a range of at least 580 nm and less than 600 nm upon irradiation of an excitation source.

8. The phosphor according to claim 7, wherein the atomic fraction of b of Li; the atomic fraction of c of Ca; the atomic fraction of d of Al; the atomic fraction of e of Si; the atomic fraction of g of O; and the atomic fraction of h of N satisfy following conditions:

$$0.03 \leq b \leq 0.11 \ ,$$

$$0.04 \leq c \leq 0.12 \ ,$$

$$0.04 \leq d \leq 0.12 \ ,$$

$$0.21 \leq e \leq 0.3 \ ,$$

$$0.015 \leq g \leq 0.05 \ ,$$

and

$$0.45 \leq h \leq 0.5 \ .$$

9. The phosphor according to claim 5, wherein the atomic fraction of a of Ce satisfies a condition:

$$0.006 \leq a \leq 0.018 \, ,$$

and
the phosphor emits fluorescence having a peak at a wavelength in a range of at least 600 nm and not exceeding 620 nm upon irradiation of an excitation source.

10. The phosphor according to claim 9, wherein the atomic fraction of b of Li; the atomic fraction of c of Ca; the atomic fraction of d of Al; and the atomic fraction of g of O satisfy following conditions:

$$0.016 \leq b \leq 0.04 \, ,$$

$$0.06 \leq c \leq 0.13 \, ,$$

$$0.06 \leq d \leq 0.13 \, ,$$

and

$$0.015 \leq g \leq 0.05 \, .$$

11. The phosphor according to claim 1, wherein the host crystal is an inorganic crystal having a composition of $x_1 LiSi_2N_3$ + $x_2 CaAlSiN_3$ + $x_3 SrAlSiN_3$ + $x_4 Si_2N_2O$ ($x_1$, $x_2$, $x_3$, and $x_4$ are numerical values of at least zero (0) and not exceeding one (1) to indicate fractions; and $x_1 + x_2 + x_3 + x_4 = 1$ in the formula), and the parameters: $x_1$, $x_2$, $x_3$, and $x_4$ satisfy following conditions:

$$0.02 \leq x_1 \leq 0.80 \, ,$$

$$0.20 \leq x_2 + x_3 \leq 0.80 \, ,$$

and

$$0.04 \leq x_4 \leq 0.30 \, ,$$

and
Ce is incorporated into the inorganic crystal in solid solution.

12. The phosphor according to claim 1, wherein the host crystal is **selected from a group consisting of** $CaAlSiN_3$, $LiSi_2N_3$, $Si_2N_2O$, a solid solution crystal thereof, **and a crystal having an identical crystal structure to any one of thus-mentioned crystals**.

13. A method of manufacturing the phosphor recited in claim 1, comprising: a step of firing a raw material mixture of metal compound inlcuding at least Ce, Li, Ca, Si, Al, and N, and, as necessary, Sr and/or O, in a nitrogen atmosphere in a temperature range of at least $15 \times 10^2$ °C and not exceeding $22 \times 10^2$ °C.

14. A light-emitting device comprising: at least an emission source and a phosphor, wherein the phosphor comprises the first phosphor recited in claim 1.

15. The light-emitting device according to claim 14 wherein the emission source is an inorganic EL device, an organic EL device, a laser diode (LD), or a light-emitting diode (LED) emitting light of a wavelength from 330 to 500 nm.

16. The light-emitting device according to claim 14 wherein the emission source is a LED or LD emitting light of a wavelength of at least 330 nm and less than 430 nm; the phosphor comprises a second phosphor emitting blue light having an emission peak at a wavelength of at least 430 nm and not exceeding 480 nm by light of a wavelength of at least 330 nm and less than 430 nm; white color light is emitted by mixing an emission color of the first phosphor and an emission color of the second phosphor.

17. The light-emitting device according to claim 16 wherein the phosphor comprises a third phosphor emitting red light having an emission peak at a wavelength of at least 600 nm and not exceeding 700 nm by light of a wavelength of at least 330 nm and less than 430 nm; white color light is emitted by mixing the emission color of the first phosphor, the emission color of the second phosphor, and an emission color of the third phosphor.

18. The light-emitting device according to claim 14, wherein the emission source is an LED or an LD emitting light of a wavelength of at least 430 nm and not exceeding 480; white color ligh is emitted by mixing an emission color of the emission source and an emission color of the first phosphor.

19. The light-emitting device according to claim 18, wherein the phosphor comprises a fourth phosphor emitting green light having an emission peak at a wavelength of at least 520 nm and not exceeding 560 nm by light of a wavelength of at least 430 nm and not exceeding 480 nm; and/or a fifth phosphor emitting red light having an emission peak at a wavelength of at least 600 nm and not exceeding 700 nm by light of a wavelength of at least 430 nm and not exceeding 480 nm, and white color ligh is emitted by mixing the emission color of the emission source, the emission color of the first phosphor, an emission color of the fourth phosphor and/or an emission color of the fifth phosphor.

20. The light-emitting device according to claim 14, wherein the phosphor comprises at least one phosphor selected from a group consisting of $\beta$-sialon phosphor activated with Eu; $\alpha$-sialon yellow phosphor activated with Eu; $Sr_2Si_5N_8$ orange phosphor activated with Eu; $(Ca, Sr)AlSiN_3$ orange phosphor activated with Eu; $CaAlSiN_3$ red phosphor activated with Eu.

21. An image diaplay device comprising: an excitation source by an electron beam, an electric field, a vacuum ultraviolet radiation ray, or ultra violet ray; and a phosphor wherein the phosphor comprises a phosphor recited in claim 1.

22. The image display device according to claim 21 further comprising: a fluorescent display tube (VFD), a field emission display (FED), a plasma display panel (PDP), or a cathode-ray tube (CRT).

**Patentansprüche**

1. Leuchtstoff, umfassend als Wirtskristall einen $CaAlSiN_3$-Kristall oder einen Kristall mit derselben Kristallstruktur wie ein $CaAlSiN_3$-Kristall, wobei der Leuchtstoff wenigstens die Elemente Li, Ca, Si, Al, O (Sauerstoff), N (Stickstoff) und Ce umfasst;
wobei der Stoffmengenanteil a von Ce und der Stoffmengenanteil b von Li der Beziehung genügen:

$$b \geq 1,2 \times a.$$

2. Leuchtstoff gemäß Anspruch 1, der weiterhin das Element Sr umfasst.

3. Leuchtstoff gemäß Anspruch 1, wobei der Stoffmengenanteil d von Al und der Stoffmengenanteil e von Si der Beziehung genügen:

$$1,5 \leq e/d \leq 9.$$

4. Leuchtstoff gemäß Anspruch 1, wobei der Stoffmengenanteil g von O und der Stoffmengenanteil h von N der Beziehung genügen:

$$0,015 \leq g/h \leq 0,1.$$

**5.** Leuchtstoff gemäß Anspruch 1, wobei der Leuchtstoff bei Bestrahlung mit einer Anregungsquelle eine Fluoreszenz emittiert, die ein Maximum bei einer Wellenlänge im Bereich von wenigstens 560 nm und nicht mehr als 620 nm aufweist.

**6.** Leuchtstoff gemäß Anspruch 5, wobei der Stoffmengenanteil a von Ce der Beziehung

$$0{,}0007 \leq a \leq 0{,}01$$

genügt und der Leuchtstoff bei Bestrahlung mit einer Anregungsquelle eine Fluoreszenz emittiert, die ein Maximum bei einer Wellenlänge im Bereich von wenigstens 560 nm und weniger als 580 nm aufweist.

**7.** Leuchtstoff gemäß Anspruch 5, wobei der Stoffmengenanteil a von Ce der Beziehung

$$0{,}0019 \leq a \leq 0{,}0085$$

genügt und der Leuchtstoff bei Bestrahlung mit einer Anregungsquelle eine Fluoreszenz emittiert, die ein Maximum bei einer Wellenlänge im Bereich von wenigstens 580 nm und weniger als 600 nm aufweist.

**8.** Leuchtstoff gemäß Anspruch 7, wobei der Stoffmengenanteil b von Li, der Stoffmengenanteil c von Ca, der Stoffmengenanteil d von Al, der Stoffmengenanteil e von Si, der Stoffmengenanteil g von O und der Stoffmengenanteil h von N den folgenden Bedingungen genügen:

$$0{,}03 \leq b \leq 0{,}11;$$

$$0{,}04 \leq c \leq 0{,}12;$$

$$0{,}04 \leq d \leq 0{,}12;$$

$$0{,}21 \leq e \leq 0{,}3;$$

$$0{,}015 \leq g \leq 0{,}05;$$

und

$$0{,}45 \leq h \leq 0{,}5.$$

**9.** Leuchtstoff gemäß Anspruch 5, wobei der Stoffmengenanteil a von Ce der Beziehung

$$0{,}006 \leq a \leq 0{,}018$$

genügt und der Leuchtstoff bei Bestrahlung mit einer Anregungsquelle eine Fluoreszenz emittiert, die ein Maximum bei einer Wellenlänge im Bereich von wenigstens 600 nm und nicht mehr als 620 nm aufweist.

**10.** Leuchtstoff gemäß Anspruch 9, wobei der Stoffmengenanteil b von Li, der Stoffmengenanteil c von Ca, der Stoffmengenanteil d von Al und der Stoffmengenanteil g von O den folgenden Bedingungen genügen:

$$0{,}016 \leq b \leq 0{,}04;$$

$$0{,}06 \leq c \leq 0{,}13;$$

$$0{,}06 \leq d \leq 0{,}13;$$

und

$$0{,}015 \leq g \leq 0{,}05.$$

**11.** Leuchtstoff gemäß Anspruch 1, wobei der Wirtskristall ein anorganischer Kristall mit der Zusammensetzung $x_1LiSi_2N_3 + x_2CaAlSiN_3 + x_3SrAlSiN_3 + x_4Si_2N_2O$ ist (wobei $x_1$, $x_2$, $x_3$ und $x_4$ numerische Werte von wenigstens null (0) und nicht mehr als eins (1) sind, um Bruchteile anzugeben; und $x_1 + x_2 + x_3 + x_4 = 1$ in der Formel ergibt) und die Parameter $x_1$, $x_2$, $x_3$ und $x_4$ den folgenden Bedingungen genügen:

$$0{,}02 \leq x_1 \leq 0{,}80;$$

$$0{,}20 \leq x_2 + x_3 \leq 0{,}80;$$

und

$$0{,}04 \leq x_4 \leq 0{,}30;$$

und
Ce in fester Lösung in den anorganischen Kristall eingebaut ist.

**12.** Leuchtstoff gemäß Anspruch 1, wobei der Wirtskristall aus der Gruppe ausgewählt ist, die aus $CaAlSiN_3$, $LiSi_2N_3$, $Si_2N_2O$, einem Kristall in Form einer festen Lösung davon und einem Kristall mit einer identischen Kristallstruktur wie einer der genannten Kristalle besteht.

**13.** Verfahren zur Herstellung des Leuchtstoffs gemäß Anspruch 1, umfassend einen Schritt des Brennens eines Rohstoffgemischs von Metallverbindungen, die wenigstens Ce, Li, Ca, Si, Al und N sowie gegebenenfalls Sr und/oder O umfassen, in einer Stickstoffatmosphäre in einem Temperaturbereich von wenigstens $15 \times 10^2$ °C und nicht mehr als $22 \times 10^2$ °C.

**14.** Lichtemittierende Vorrichtung, umfassend wenigstens eine Emissionsquelle und einen Leuchtstoff, wobei der Leuchtstoff den in Anspruch 1 genannten ersten Leuchtstoff umfasst.

**15.** Lichtemittierende Vorrichtung gemäß Anspruch 14, wobei die Emissionsquelle eine anorganische EL-Vorrichtung, eine organische EL-Vorrichtung, eine Laserdiode (LD) oder eine lichtemittierende Diode (LED), die Licht mit einer Wellenlänge von 330 bis 500 nm emittiert, ist.

**16.** Lichtemittierende Vorrichtung gemäß Anspruch 14, wobei die Emissionsquelle eine LED oder LD ist, die Licht mit einer Wellenlänge von wenigstens 330 nm und weniger als 430 nm emittiert; der Leuchtstoff einen zweiten Leuchtstoff umfasst, der bei Anregung mit Licht einer Wellenlänge von wenigstens 330 nm und weniger als 430 nm blaues Licht mit einem Emissionsmaximum bei einer Wellenlänge von wenigstens 430 nm und nicht mehr als 480 nm emittiert, und durch Mischen der Emissionsfarbe des ersten Leuchtstoffs und der Emissionsfarbe des zweiten Leuchtstoffs Licht mit weißer Farbe emittiert wird.

**17.** Lichtemittierende Vorrichtung gemäß Anspruch 16, wobei der Leuchtstoff einen dritten Leuchtstoff umfasst, der bei Anregung mit Licht einer Wellenlänge von wenigstens 330 nm und weniger als 430 nm rotes Licht mit einem Emissionsmaximum bei einer Wellenlänge von wenigstens 600 nm und nicht mehr als 700 nm emittiert, und durch Mischen der Emissionsfarbe des ersten Leuchtstoffs, der Emissionsfarbe des zweiten Leuchtstoffs und der Emissionsfarbe des dritten Leuchtstoffs Licht mit weißer Farbe emittiert wird.

**18.** Lichtemittierende Vorrichtung gemäß Anspruch 14, wobei die Emissionsquelle eine LED oder LD ist, die Licht mit einer Wellenlänge von wenigstens 430 nm und nicht mehr als 480 nm emittiert, und durch Mischen der Emissionsfarbe der Emissionsquelle und der Emissionsfarbe des ersten Leuchtstoffs Licht mit weißer Farbe emittiert wird.

**19.** Lichtemittierende Vorrichtung gemäß Anspruch 18, wobei der Leuchtstoff einen vierten Leuchtstoff, der bei Anregung mit Licht einer Wellenlänge von wenigstens 430 nm und nicht mehr als 480 nm grünes Licht mit einem Emissionsmaximum bei einer Wellenlänge von wenigstens 520 nm und nicht mehr als 560 nm emittiert, und/oder einen fünften Leuchtstoff, der bei Anregung mit Licht einer Wellenlänge von wenigstens 430 nm und nicht mehr als 480 nm rotes Licht mit einem Emissionsmaximum bei einer Wellenlänge von wenigstens 600 nm und nicht mehr als 700 nm emittiert, umfasst und durch Mischen der Emissionsfarbe der Emissionsquelle, der Emissionsfarbe des ersten Leuchtstoffs, der Emissionsfarbe des vierten Leuchtstoffs und/oder der Emissionsfarbe des fünften Leuchtstoffs Licht mit weißer Farbe emittiert wird.

**20.** Lichtemittierende Vorrichtung gemäß Anspruch 14, wobei der Leuchtstoff wenigstens einen Leuchtstoff umfasst, der aus der Gruppe ausgewählt ist, die aus mit Eu aktiviertem $\beta$-Sialon-Leuchtstoff, mit Eu aktiviertem gelben $\alpha$-Sialon-Leuchtstoff, mit Eu aktiviertem orangefarbenen $Sr_2Si_5N_8$-Leuchtstoff, mit Eu aktiviertem orangefarbenen $(Ca,Sr)AlSiN_3$-Leuchtstoff und mit Eu aktiviertem roten $CaAlSiN_3$-Leuchtstoff besteht.

**21.** Bildanzeigevorrichtung, umfassend eine Anregungsquelle durch einen Elektronenstrahl, ein elektrisches Feld, einen Strahl von Vakuum-Ultraviolettstrahlung oder einen ultravioletten Strahl und einen Leuchtstoff, wobei der Leuchtstoff einen Leuchtstoff gemäß Anspruch 1 umfasst.

**22.** Bildanzeigevorrichtung gemäß Anspruch 21, weiterhin umfassend: eine Fluoreszenzanzeige (VFD), einen Feldemissionsbildschirm (FED), einen Plasmabildschirm (PDP) oder einen Kathodenstrahlröhrenbildschirm (CRT).

## Revendications

**1.** Luminophore comprenant comme cristal hôte un cristal de $CaAlSiN_3$ ou un cristal ayant la même structure cristalline que ledit cristal de $CaAlSiN_3$, le luminophore incluant au moins des éléments Li, Ca, Si, Al, O (oxygène), N (azote) et Ce,
dans lequel la fraction atomique, a, de Ce et la fraction atomique, b, de Li satisfont :

$$b \geq 1,2 \times a.$$

**2.** Luminophore selon la revendication 1, comprenant en outre l'élément Sr.

**3.** Luminophore selon la revendication 1, dans lequel la fraction atomique, d, de Al et la fraction atomique, e, de Si satisfont :

$$1,5 \leq e/d \leq 9.$$

**4.** Luminophore selon la revendication 1, dans lequel la fraction atomique, g, de O et la fraction atomique, h, de N satisfont :

$$0,015 \leq g/h \leq 0,1.$$

**5.** Luminophore selon la revendication 1, dans lequel le luminophore émet une fluorescence ayant un pic à une longueur d'onde comprise dans la gamme d'au moins 560 nm et n'excédant pas 620 nm lors d'une irradiation avec une source d'excitation.

**6.** Luminophore selon la revendication 5, dans lequel la fraction atomique, a, de Ce satisfait la condition :

$$0,0007 \leq a \leq 0,01,$$

et
le luminophore émet une fluorescence ayant un pic à une longueur d'onde comprise dans la gamme d'au moins 560 nm et moins de 580 nm lors d'une irradiation avec une source d'excitation.

7. Luminophore selon la revendication 5, dans lequel la fraction atomique, a, de Ce satisfait la condition :

$$0,0019 \leq a \leq 0,0085,$$

et
le luminophore émet une fluorescence ayant un pic à une longueur d'onde comprise dans la gamme d'au moins 580 nm et moins de 600 nm lors d'une irradiation avec une source d'excitation.

8. Luminophore selon la revendication 7, dans lequel la fraction atomique, b, de Li, la fraction atomique, c, de Ca, la fraction atomique, d, de Al, la fraction atomique, e, de Si, la fraction atomique, g, de O et la fraction atomique, h, de N satisfont les conditions suivantes :

$$0,03 \leq b \leq 0,11 \; ;$$

$$0,04 \leq c \leq 0,12 \; ;$$

$$0,04 \leq d \leq 0,12 \; ;$$

$$0,21 \leq e \leq 0,3 \; ;$$

$$0,015 \leq g \leq 0,05 \; ;$$

et

$$0,45 \leq h \leq 0,5.$$

9. Luminophore selon la revendication 5, dans lequel la fraction atomique, a, de Ce satisfait la condition :

$$0,006 \leq a \leq 0,018,$$

et
le luminophore émet une fluorescence ayant un pic à une longueur d'onde comprise dans la gamme d'au moins 600 nm et n'excédant pas 620 nm lors d'une irradiation avec une source d'excitation.

10. Luminophore selon la revendication 9, dans lequel la fraction atomique, b, de Li, la fraction atomique, c, de Ca, la fraction atomique, d, de Al et la fraction atomique, g, de O satisfont les conditions suivantes :

$$0,016 \leq b \leq 0,04 \; ;$$

$$0,06 \leq c \leq 0,13 \; ;$$

$$0,06 \leq d \leq 0,13 \; ;$$

et

$$0,015 \leq g \leq 0,05.$$

**11.** Luminophore selon la revendication 1, dans lequel le cristal hôte est un cristal inorganique ayant une composition de $x_1 LiSi_2N_3 + x_2 CaAlSiN_3 + X_3 SrAlSiN_3 + x_4 Si_2N_2O$ (où $x_1$, $x_2$, $x_3$ et $x_4$ sont des valeurs numériques d'au moins zéro (0) et n'excédant pas un (1), pour indiquer des fractions, et $x_1 + x_2 + x_3 + x_4 = 1$ dans la formule), et les paramètres $x_1$, $x_2$, $x_3$ et $x_4$ satisfont les conditions suivantes :

$$0,02 \leq x_1 \leq 0,80 \; ;$$

$$0,20 \leq x_2 + x_3 \leq 0,80 \; ;$$

et

$$0,04 \leq x_4 \leq 0,30 \; ;$$

et
Ce est incorporé dans le cristal inorganique en solution solide.

**12.** Luminophore selon la revendication 1, dans lequel le cristal hôte est choisi dans le groupe consistant en $CaAlSiN_3$, $LiSi_2N_3$, $Si_2N_2O$, un cristal étant une solution solide de ceux-ci, et un cristal ayant une structure cristalline identique avec l'une quelconque de celles des cristaux susmentionnés.

**13.** Procédé pour produire le luminophore selon la revendication 1, comprenant une étape consistant à cuire un mélange de matières premières étant des composés métalliques comprenant au moins Ce, Li, Ca, Si, Al et N et, si né-cessaire, Sr et/ou O dans une atmosphère d'azote dans une gamme de températures d'au moins $15 \times 10^2$ °C et n'excédant pas $22 \times 10^2$ °C.

**14.** Dispositif d'émission de lumière, comprenant au moins une source d'émission et un luminophore, dans lequel le luminophore comprend le premier luminophore selon la revendication 1.

**15.** Dispositif d'émission de lumière selon la revendication 14, dans lequel ladite source d'émission est un dispositif EL inorganique, un dispositif EL organique, une diode laser (LD), ou une diode électroluminescente (DEL) émettant de la lumière ayant une longueur d'onde de 330 à 500 nm.

**16.** Dispositif d'émission de lumière selon la revendication 14, dans lequel ladite source d'émission est une DEL ou LD émettant de la lumière ayant une longueur d'onde d'au moins 330 nm et moins de 430 nm, le luminophore comprend un deuxième luminophore émettant de la lumière bleue ayant un pic d'émission à une longueur d'onde d'au moins 430 nm et n'excédant pas 480 nm lors d'une excitation par de la lumière d'une longueur d'onde d'au moins 330 nm et moins de 430 nm, de la lumière de couleur blanche étant émise par le mélange d'une couleur d'émission du premier luminophore et d'une couleur d'émission du deuxième luminophore.

**17.** Dispositif d'émission de lumière selon la revendication 16, dans lequel le luminophore comprend un troisième luminophore émettant de la lumière rouge ayant un pic d'émission à une longueur d'onde d'au moins 600 nm et n'excédant pas 700 nm lors d'une excitation par de la lumière d'une longueur d'onde d'au moins 330 nm et moins de 430 nm, de la lumière de couleur blanche étant émise par le mélange d'une couleur d'émission du premier luminophore, de la couleur d'émission du deuxième luminophore et d'une couleur d'émission du troisième luminophore.

**18.** Dispositif d'émission de lumière selon la revendication 14, dans lequel ladite source d'émission est une DEL ou LD émettant de la lumière ayant une longueur d'onde d'au moins 430 nm et n'excédant pas 480 nm, de la lumière de couleur blanche étant émise par le mélange d'une couleur d'émission de la source d'émission et d'une couleur d'émission du premier luminophore.

**19.** Dispositif d'émission de lumière selon la revendication 18, dans lequel le luminophore comprend un quatrième luminophore émettant de la lumière verte ayant un pic d'émission à une longueur d'onde d'au moins 520 nm et n'excédant pas 560 nm lors d'une excitation par de la lumière d'une longueur d'onde d'au moins 430 nm et n'excédant pas 480 nm, et/ou un cinquième luminophore émettant de la lumière rouge ayant un pic d'émission à une longueur d'onde d'au moins 600 nm et n'excédant pas 700 nm lors d'une excitation par de la lumière d'une longueur d'onde d'au moins 430 nm et n'excédant pas 480 nm, de la lumière de couleur blanche étant émise par le mélange de la couleur d'émission de la source d'excitation, la couleur d'émission du premier luminophore, une couleur d'émission du quatrième luminophore et/ou une couleur d'émission du cinquième luminophore.

**20.** Dispositif d'émission de lumière selon la revendication 14, dans lequel le luminophore comprend au moins un luminophore choisi dans le groupe consistant en luminophore $\beta$-sialon activé par Eu, luminophore jaune, $\alpha$-sialon activé par Eu, luminophore orange $Sr_2Si_5N_8$ activé par Eu, luminophore orange $(Ca,Sr)AlSiN_3$ activé par Eu, luminophore rouge $CaAlSiN_3$ activé par Eu.

**21.** Dispositif d'affichage d'image comprenant une source d'excitation par un faisceau d'électrons, un champ électrique, des rayons ultraviolets de vide, ou des rayons ultraviolets ; et un luminophore, dans lequel ledit luminophore comprend un luminophore selon la revendication 1.

**22.** Dispositif d'affichage d'image selon la revendication 21, comprenant en outre un afficheur fluorescent (VFD), un afficheur à émission de champ (FED), un panneau d'affichage à plasma (PDP), ou un écran à tube cathodique (CRT).

**Fig. 1**

**Fig. 2**

*Fig. 3*

*Fig. 4*

*Fig. 5*

Wavelength (nm)

*Fig. 6*

Wavelength (nm)

*Fig. 7*

*Fig. 8*

*Fig. 9*

*Fig. 10*

*Fig. 11*

*Fig. 12*

Fig. 13

**REFERENCES CITED IN THE DESCRIPTION**

**Patent documents cited in the description**

- JP 3837588 B
- JP 2007231245 A
- JP H05152609 B
- JP H0799345 B
- JP 2927279 B

**Non-patent literature cited in the description**

- **Y.Q.LI et al.** Yellow-Orange-Emitting CaAlSiN3:Ce3+ Phosphor: Structure, Photoluminescence, and Application in White LEDs. *Chem. Mater.,* 2008, vol. 20, 6704-6714
- White light-emitting diodes (LEDs) using (oxy)nitride phosphors. **R-J XIE et al.** Journal of Physics D. Applied Physics. IOP Publishing, 21 July 2008, vol. 41, 144013
- $\alpha$-Sialon ceramics: a review. **CAO G Z et al.** Chemistry of Materials. American Chemical Society, 01 March 1991, vol. 3, 242-252
- **K. UHEDA et al.** Host lattice materials in the system Ca3N2-AlN-Si3N4 for white light emitting diode. *Physica Status Solidi (A),* 01 September 2006, vol. 203 (11), 2712-2717
- Highly efficient white-light-emitting diodes fabricated with short-wavelength yellow oxynitride phosphors. **XIE RONG-JUN et al.** Applied Physics Letters. American Institute of Physics, 06 March 2006, vol. 88, 101104-101104
- **R-J XIE et al.** Strong Green Emission from $\alpha$-SiAlON Activated by Divalent Ytterbium under Blue Light Irradiation. *The Journal of Physical Chemistry B,* 23 April 2005, vol. 109 (19), 9490-9494